# EUROPÄISCHE PATENTSCHRIFT

(11) **EP 4 449 486 B1**
(45) Veröffentlichungstag und Bekanntmachung des Hinweises auf die Patenterteilung: **28.01.2026**
(21) Anmeldenummer: 21840561.1
(22) Anmeldetag: 17.12.2021
(51) Int. Cl.: H01L 21/68, H01L 23/544

(54) **VORRICHTUNG UND VERFAHREN ZUR JUSTIERUNG EINES ERFASSUNGSMITTELS**
DEVICE AND METHOD FOR ADJUSTING A DETECTION MEANS
DISPOSITIF ET PROCÉDÉ DE RÉGLAGE D'UN MOYEN DE DÉTECTION

(43) Veröffentlichungstag der Anmeldung: 23.10.2024
(73) Patentinhaber: EV Group E. Thallner GmbH, 4782 St. Florian am Inn (AT)
(72) Erfinder: ROHRINGER, Harald, 4782 St. Florian am Inn (AT); FINGER, Martin, 4782 St. Florian am Inn (AT); ZINNER, Dominik, 4782 St. Florian am Inn (AT)
(74) Vertreter: Schneider, Sascha
(86) Internationale Anmeldenummer: PCT/EP2021/086381
(87) Internationale Veröffentlichungsnummer: WO 2023/110114

(56) Entgegenhaltungen:
- EP-A1- 3 734 650
- WO-A1-2014/202106
- CN-A- 111 354 714
- CN-A- 111 933 618
- DE-A1- 102018 100 066
- US-A- 5 843 831

## Beschreibung

Die vorliegende Erfindung betrifft eine Vorrichtung und Verfahren zur Justierung eines Erfassungsmittels. Die Vorrichtung und das Verfahren sind insbesondere zur Justierung von Erfassungsmitteln in Ausrichtungs- und Bearbeitungsanlagen der Halbleiterindustrie geeignet.

In der Halbleiterindustrie werden Ausrichtungsanlagen (engl.: aligner) verwendet, um Substrate, insbesondere Wafer, zueinander auszurichten oder zu anderen Bauteilen auszurichten. Substrate können jede beliebige Form besitzen, sind aber bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll.

Das Fügen von ausgerichteten Halbleitersubstraten wird als Bonden bezeichnet. Dabei ist eine möglichst genaue Ausrichtung der Substrate beziehungsweise des Substrates gefordert, um Bondfehler zu vermeiden und die Ausschlussrate gering zu halten. Zudem ist für viele Anwendungen die höchstmögliche Genauigkeit gefordert. Dazu werden Ausrichtungsmarken auf den Substraten oder den Substrathaltern relativ zueinander vermessen. Dabei kommen, insbesondere optische, Erfassungsmittel zum Einsatz, mittels derer die Ausrichtungsmarkierungen erfasst und die Substrate ausgerichtet werden.

Beispielsweise werden bei dem Bonden die zu verbondenden Substrate zueinander ausgerichtet und in einem weiteren Prozessschritt miteinander verbunden. Dabei ist stets eine besonders genaue Ausrichtung der Substrate zueinander notwendig. Beim Bonden handelt es sich in weiterem Text bevorzugt um Fusionsbonden. Ausrichtungsvorgänge, bei denen sich die Ausrichtungsmarkierungen an den zu verbondenden Substratoberflächen befinden werden als face-to-face Ausrichtungen bezeichnet. Beim Ausrichten entstehen durch größere Verfahrwege auch größere Ausrichtungsfehler.

Ein weiteres Problem mit dem Stand der Technik besteht darin, dass steigenden Ausrichtungsgenauigkeitsanforderungen nicht mehr mit einfachen Mitteln erreicht werden können. In Bezug auf Verfahren bei denen Substrate relativ zu Referenzpunkten vermessen und beispielsweise nach einer Annäherung zum Kontaktieren blind ausgerichtet werden, werden die neuen Ausrichtungsgenauigkeitsanforderungen nicht erreicht.

Beispielsweise basiert die Druckschrift US6214692B1 auf dem Vergleich und der Positionskorrektur zweier Bilder von Justierungsmarkierungen. Die Lage von Ausrichtungsmarkierungen auf den beiden, face-to-face angeordneten Substraten, wird einzeln mittels eines Kamerasystems erfasst. Aus einer berechneten Relativlage und Relativposition der Ausrichtungsmarkierungen wird ein Positioniertisch (Substrathalter und Stage) so angesteuert, dass die Fehlposition korrigiert wird.

Die weitere Druckschrift US10692747B2 basiert auf dem Vergleich und der Positionskorrektur insgesamt dreier Bilder von ebenen Ausrichtungsmarkierungen. Die Lage von Ausrichtungsmarkierungen auf den beiden, face-to-face angeordneten Substraten, wird einzeln mittels eines Kamerasystems erfasst. Von einer dritten Erfassungseinheit wird eine dritte Ausrichtungsmarkierung erfasst, mit welcher eine Korrelation einer Ausrichtungsmarke des Substrats zur Rückseite des Substrathalters oder zur Rückseite des Substrates hergestellt wird, sodass eine genauere Ausrichtung zweier Substrate ermöglicht wird.

Weitere Vorrichtungen und Verfahren sind aus den Druckschriften EP3734650A1 sowie CN111354714A bekannt.

Insofern ist eine Sichtkontrolle bei einer face-to-face Ausrichtung von zwei Substraten nicht möglich beziehungsweise nur möglich, wenn zumindest eins der Substrate zumindest teilweise transparent ist. Ein genaues Ausrichten der Oberflächen bei einer face-to-face Ausrichtung ist daher nur aufwendig und eingeschränkt möglich.

Es hat sich insbesondere als nachteilig herausgestellt, dass die optischen Erfassungsmittel der einzelnen Ausrichtungsmarkierungen in einer ungenau definierten Lage zum Substrathalter und damit auch zum dem später auf dem Substrathalter angeordneten Substrat positioniert sind. Durch die ungenaue Position der Erfassungsmittel benötigt die Erfassung der einzelnen Ausrichtungsmarkierungen üblicherweise eine Nachstellbewegung in der lateralen Ebene des Substrathalters und eine Fokussierbewegung. Durch die insbesondere gesteuerten Bewegungen der Erfassungsmitteln ist die räumliche Lage der Erfassungsmittel, insbesondere optischer Erfassungsmittel, beispielsweise Messmikroskope, häufig so ungenau, dass mit deren Hilfe keine genaue Messung und dadurch keine hinreichend genaue Ausrichtung des Substratstapels möglich ist.

Die Nachstellbewegungen insbesondere der Optiken zur Erfassung der Ausrichtungsmarken verlaufen neben der benötigten Bewegung mit dazu überlagerten, parasitären Bewegungen, welche Abweichungen von der idealen Bewegung der jeweiligen Optik verursachen. Somit kann es bei einer Bewegung zu einer Schiefstellung der zentralen Achse der Erfassungsmittel kommen, welche sich wiederum negativ auf die Ausrichtungsgenauigkeit auswirkt.

Es ist daher Aufgabe der vorliegenden Erfindung eine verbesserte Vorrichtung und ein verbessertes Verfahren zur Justierung eines Erfassungsmittels aufzuzeigen, welche die im Stand der Technik aufgeführten Nachteile zumindest zum Teil beseitigen, insbesondere vollständig beseitigen. Es ist zudem Aufgabe der vorliegenden Erfindung eine verbesserte Vorrichtung und ein verbessertes Verfahren zur Justierung eines Erfassungsmittels aufzuzeigen. Es ist ferner Aufgabe der vorliegenden Erfindung eine Vorrichtung und ein Verfahren zur Justierung eines Erfassungsmittels aufzuzeigen, welche die Winkelstellung relativ zum Substrathalter berücksichtigt und einfach durchführbar ist. Es ist insbesondere eine weitere Aufgabe der vorliegenden Erfindung ein Verfahren und eine Vorrichtung zum verbesserten Ausrichten von Substraten aufzuzeigen, welches besonders zuverlässig, genau und einfach einen Keilfehler zwischen dem Substrathalter und dem Erfassungsmittel bestimmt und ausgleicht, also justiert.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Demnach betrifft die Erfindung eine Vorrichtung zur Justierung eines Erfassungsmittels, zumindest aufweisend:
i) einen Substrathalter zur Aufnahme eines Substrates,
ii) mindestens ein zu dem Substrathalter ortsfest angeordnetes Justiermarkierungsfeld mit Justiermarken und
iii) das Erfassungsmittel zur Erfassung der Justiermarken,
dadurch gekennzeichnet, dass das Erfassungsmittel anhand von übereinander angeordneten Justiermarken des Justiermarkierungsfeldes relativ zu dem Substrathalter justierbar ist, wobei der Substrathalter auf einer Substrathalteroberfläche regelmäßig angeordnete Erhöhungen zur Bereitstellung einer Substrataufnahmefläche aufweist und wobei mehrere jeweils Justiermarken aufweisende Justiermarkierungsfelder regelmäßig zueinander versetzt zwischen den Erhöhungen angeordnet sind.

Des Weiteren betrifft die Erfindung ein Verfahren zur Justierung eines Erfassungsmittels mit zumindest den folgenden Schritten:
i) Bereitstellung eines Substrathalters mit einem ortsfest zu dem Substrathalter angeordneten Justiermarkierungsfeldes mit Justiermarken und
i) Justierung des Erfassungsmittel relativ zu dem Substrathalter,
dadurch gekennzeichnet, dass das Erfassungsmittel anhand von übereinander angeordneten Justiermarken des Justiermarkierungsfeldes justiert wird, wobei der Substrathalter auf einer Substrathalteroberfläche regelmäßig angeordnete Erhöhungen zur Bereitstellung einer Substrataufnahmefläche aufweist und wobei mehrere jeweils Justiermarken aufweisende Justiermarkierungsfelder regelmäßig zueinander versetzt zwischen den Erhöhungen angeordnet sind.

In anderen Worten wird das Erfassungsmittel vorteilhaft anhand von zwei in unterschiedlicher Höhe übereinander angeordneten Justiermarkierungen eines Justiermarkierungsfeldes ausgerichtet. Dabei wird besonders bevorzugt ein Keilfehler (Winkelfehler) zwischen Erfassungsmittel und Substrathalter ausgeglichen. Eine Schrägstellung des Erfassungsmittels kann somit anhand eines einzigen Justiermarkierungsfeldes mit übereinander angeordneten Justiermarken justiert und kalibriert werden. In der vorliegenden Schrift werden die Begriffe Keilfehler und Winkelfehler als Synonyme verwendet.

Da das Erfassungsmittel bevorzugt gleichzeitig auch zum Auslesen von Ausrichtungsmarken (auf dem Substrat oder auf dem Substrathalter) beim Bonden ausgebildet ist, wird somit auch die Ausrichtungsgenauigkeit durch die vorherige Justierung erhöht. Zudem ist der insbesondere Substrathalter zur möglichst planaren Aufnahme und Bereitstellung eines Substrates ausgebildet. Relativ zu dem Substrathalter ist das Justiermarkierungsfeld ortsfest angeordnet, so dass die jeweiligen Justiermarken ebenfalls in Bezug auf den Substrathalter eine bestimmte beziehungsweise bekannte Position aufweisen. Dabei ist bevorzugt die jeweilige Lage der einzelnen Justiermarken in dem Justiermarkierungsfeld bekannt, so dass nach einer Erfassung von zwei übereinander angeordneten Justiermarken durch das Erfassungsmittel, eine Ausrichtung anhand der erfassten Justiermarkierungen mit bekannter Lage durchführbar ist. Dazu kann das Erfassungsmittel beziehungsweise ein Parallelachsenfehler ohne eine Relativbewegung parallel zum Substrathalter (x-y-Achse) anhand der übereinander geordneten Justiermarken ausgeglichen werden. Nach einer solchen Justierung ist insbesondere eine die Erfassungsachse des Erfassungsmittels senkrecht zu dem Substrathalter ausgerichtet, so dass keine Schrägstellung mehr besteht beziehungsweise ein Winkelfehler der Erfassungsmittel durch die Vorrichtung beseitigt werden kann. Da jeder unbekannte Winkelfehler eines Erfassungsmittels auch einen Alignment-Fehler bewirken kann, wird somit auch die Ausschlussrate bei der Substratbearbeitung reduziert.

Dazu ist das Erfassungsmittel insbesondere durch eine Bewegungsvorrichtung insbesondere entlang einer Fokusachse bewegbar (senkrecht zum Substrathalter in z-Richtung). Zudem kann vorzugsweise eine Kippbeziehungsweise Schrägstellung der Erfassungseinheit durch besonders sensible Aktuatoren ausgeglichen werden. Auch kann der ermittelte Keilfehler zwischen der Erfassungseinheit und dem Substrathalter beziehungsweise und der Substrataufnahmefläche des Substrathalters auch durch eine Ausgleichsbewegung des Substrathalters erfolgen.

Die Justierungsmarken sind insbesondere am und/oder im Substrathalter angebrachte Markierungen, welche zumindest eine Justierung des Erfassungsmittels relativ zum Substrathalter ermöglichen. Bevorzugt sind mehrere Justierungsmarkierungsfelder mit jeweils eigenen Justiermarken in bestimmten Bereichen, welche vorzugsweise mit den Positionen von späteren Ausrichtungsmarken fluchten, verteilt über dem Substrathalte angeordnet.

Somit kann die Erfassungseinheit vorteilhaft Justiermarken eines Justiermarkierungsfeldes unabhängig von der x-y-Position erfassen. Zudem ist dann eine weitere Bewegung zum Auslesen der Ausrichtungsmarken möglich, ohne dass die Erfassungsmittel in x-y-Richtung verfahren müssen.

Ein besonderer Vorteil der Vorrichtung und des Verfahrens zum Justieren ist, dass kein Referenzwafer oder ein anderes zusätzliches Messsystem notwendig ist, um das Erfassungsmittel und den Substrathalter zueinander auszurichten. Diese Form der Kalibrierung kann somit vorteilhaft einfach und oft zwischen den einzelnen Bearbeitungsschritten erfolgen. Ein weiterer ganz besonderer Vorteil der Vorrichtung und des Verfahrens zum Justieren ist, dass durch mehrere Justiermarkierungsfelder an den unterschiedlichen Positionen das Erfassungsmittel speziell dort justiert wird, wo auch gemessen wird. Externe Einflüsse, wie beispielsweise die Durchbiegung des Tisches durch das Gewicht der Optik, werden dadurch berücksichtigt und können im Nachhinein keine Schrägstellung der Erfassungseinheit bewirken.

Ein Substrathalter mit zumindest einem Justierungsmarkierungsfeld kann aus mehreren diskreten Bauteilen bestehen. Bevorzugt ist die Substrataufnahmefläche eine reproduzierbar, zumindest geringfügig verformbare Platte, welche insbesondere zwangfrei im Substrathalter gehalten wird. Ein Justierungsmarkierungsfeld besteht zumindest aus einer Justierungsmarke und einer weiteren Justierungsmarke.

Das Justierungsmarkierungsfeld ist ortsfest zu dem Substrathalter beziehungsweise zu der Substrathalteroberfläche angeordnet. Dabei ist insbesondere die genaue Lage des Justierungsmarkierungsfeldes und die jeweilige Lage der Justierungsmarken in dem Justierungsmarkierungsfeld relativ zu dem bzw. auf dem Substrathalter bekannt. Die Justierungsmarken beziehungsweise zumindest zwei Justierungsmarken des Justierungsmarkierungsfeldes sind dabei übereinander angeordnet.

In einer bevorzugten Ausführungsform der Vorrichtung ist vorgesehen, dass die Justiermarken des Justiermarkierungsfeldes in einer ersten Ebene und einer zweiten Ebene angeordnet sind, und wobei die erste Ebene und die zweiten Ebene parallel zueinander angeordnet sind, und wobei die erste Ebene und die zweite Ebene einen Abstand zueinander aufweisen. In anderen Worten weisen die Justiermarken unterschiedlicher Ebenen einen bekannten und gleichbleibenden Abstand zueinander auf. Auf diese Wiese kann eine Justierung vorteilhaft genau durchgeführt werden. Bevorzugt sind die Ebenen sämtlicher Justiermarkierungsmarkenfelder zum Substrathalter identisch angeordnet. Anhand des bekannten Abstands kann somit vorteilhaft genau der Keilfehler zwischen dem Erfassungsmittel und dem Substrathalter bestimmt, insbesondere berechnet, werden.

In einer weiteren bevorzugten Ausführungsform der Vorrichtung ist vorgesehen, dass das Erfassungsmittel durch eine Relativbewegung zwischen dem Erfassungsmittel und dem Substrathalter justierbar ist. In anderen Worten wird nach einer Erfassung einer ersten Justiermarke einer ersten Ebene durch eine Bewegung des Substrathalters oder des Erfassungsmittels in z-Richtung eine zweite Justiermarke einer zweiten Ebene des Justiermarkierungsfeldes erfasst. Die Länge des Wegs der Bewegung kann mit dem Abstand zwischen den Ebenen des Justiermarkierungsfeldes verglichen werden und somit eine Schrägstellung beziehungsweise ein Keilfehler bestimmt werden.

In einer weiteren bevorzugten Ausführungsform der Vorrichtung ist vorgesehen, dass das Erfassungsmittel durch einen Fokuswechsel des Erfassungsmittels justierbar ist. In anderen Worten verschiebt das Erfassungsmittel seinen Fokusbereich, um die jeweilig andere Justiermarke zu erfassen. Dabei erfolgt diese Fokussierbewegung vorteilhaft ohne eine Relativbewegung des Erfassungsmittels oder des Substrathalters. Anhand der Fokussierbewegung, z.B. der Optik, wird somit der auf diese Weise ermittelte Abstand zwischen den Justiermarken unterschiedlicher Ebenen gemessen und mit dem bekannten Abstand verglichen. Auf diese Weise ist eine besonders genau Justierung des Substrathalters zu dem Erfassungsmittel ohne einen Fehler in Folge einer Relativbewegung möglich. Mit dieser Umfokussierung des Erfassungsmittels lassen sich laterale Verschiebungen erkennen und entsprechend korrigieren, wenn bei der Fokussierbewegung ein scheinbarer lateraler Versatz der Justiermarken zweier Ebenen erfasst wird. Dabei bleibt vorzugsweise der Substrathalter in seiner Position fixiert.

In einer weiteren bevorzugten Ausführungsform der Vorrichtung ist vorgesehen, dass die Justiermarken der ersten Ebene und die Justiermarken der zweiten Ebene übereinander fluchtend angeordnet sind. In diesem Fall ist das Justiermarkierungsfeld und das Erfassungsmittel so ausgebildet, dass die Erfassung unterschiedlicher fluchtender Justiermarken möglich ist. Beispielsweise ist das Justiermarkierungsfeld für bestimmte Wellenlängen transparent.

In einer weiteren bevorzugten Ausführungsform der Vorrichtung ist vorgesehen, dass die Justiermarken der ersten Ebene und die Justiermarken der zweiten Ebene übereinander und regelmäßig versetzt zueinander angeordnet sind. Auf diese Weise können die Justiermarken durch die Erfassungseinheit vorteilhaft einfach erfasst werden.

In einer weiteren bevorzugten Ausführungsform der Vorrichtung ist vorgesehen, dass die Justiermarken der ersten Ebene und die Justiermarken der zweiten Ebene stufenartig versetzt zueinander auf unterschiedlichen Schichten angeordnet sind. Auf diese Weise verdeckt vorteilhaft kein Material des Justiermarkierungsfeldes die Justiermarken unterschiedlicher Ebenen. Weiterhin kann aus mehreren Erfassungsmitteln gewählt werden.

In einer weiteren bevorzugten Ausführungsform der Vorrichtung ist vorgesehen, dass die Justiermarken jeweils zusätzlich einen individuellen und von dem Erfassungsmittel erfassbaren Informationsgehalt aufweisen. Auf diese Weise ich die Lage der jeweils erfassten Justiermarke im Justiermarkierungsfeld und/oder in Bezug auf den Substrathalter bekannt. Die bekannten x-y-Positionen der Justiermarken, sowie deren einzelne Muster (z.B. Pixel) Positionen sind dabei vorzugsweise bekannt. Somit kann vorteilhaft bei der Bestimmung des Keilfehlers der Informationsgehalt (z.B. als Bar-Code bereitgestellt) einbezogen werden. Somit ist eine noch genauere und zuverlässigere Ermittlung des Keilfehlers möglich. Weiterhin wird somit eine spätere relativ Bestimmung der Lage des Substartes anhand der Ausrichtungsmarken ermöglicht.

In einer weiteren bevorzugten Ausführungsform der Vorrichtung ist vorgesehen, dass das Erfassungsmittel ein optisches Erfassungsmittel, insbesondere eine Optik mit einer bestimmbaren optischen Zentralachse ist. Diese Zentralachse steht bei einer optimalen Ausrichtung genau senkrecht zu dem Substrathalter beziehungsweise der Substrathalteroberfläche und somit auch auf den Justiermarken. Anhand einer Umfokussierung beziehungsweise eines Fokuswechsels, kann somit besonders exakt die Verschiebung des Fokusbereiches entlang der optischen Zentralachse bestimmt werden.

In einer weiteren bevorzugten Ausführungsform der Vorrichtung ist vorgesehen, dass der Substrathalter auf einer Substrathalteroberfläche regelmäßig angeordnete Erhöhungen zur Bereitstellung einer Substrataufnahmefläche aufweist und mehrere jeweils Justiermarken aufweisende Justiermarkierungsfelder regelmäßig zueinander versetzt zwischen den Erhöhungen angeordnet sind. Bei den Erhöhungen handelt es sich vorzugsweise um Noppen oder Pinne. Auf diese Weise ist die Kontaktfläche zwischen dem Substrat und dem Substrathalter beziehungsweise der Substrataufnahmefläche vorteilhaft klein, so dass eine Kontamination der Oberflächen des Substrates minimiert, beziehungsweise verhindert werden kann. Durch mehrere zwischen den Erhöhungen angeordneter Justiermarkierungsfelder, kann vorteilhaft an einer Vielzahl von Positionen der Keilfehler bestimmt werden. Eine Relativbewegung des Erfassungsmittels in x-y-Richtung, also entlang der Substrathalteroberfläche, ist somit nicht erforderlich. Vielmehr kann auf diese Weise vorteilhaft genau und positionsunabhängig der Keilfehler durch das Erfassungsmittel bestimmt werden und das Erfassungsmittel genau ausgerichtet beziehungsweise justiert werden.

In einer weiteren bevorzugten Ausführungsform der Vorrichtung ist vorgesehen, dass das mindestens eine Justiermarkierungsfelder relativ zu der Substrathalteroberfläche eine geringere Höhe aufweist als die Erhöhungen. Die Erhöhungen stehen somit relativ zu den Justiermarkierungsfeldern in Bezug auf die Substrathalteroberfläche vor. Auf diese Weise kann das Substrat vorteilhaft nicht durch die Justiermarkierungsfelder kontaminiert werden, da ein Kontakt lediglich mit den dafür vorgesehenen Erhöhungen erfolgt.

In einer weiteren bevorzugten Ausführungsform der Vorrichtung ist vorgesehen, dass eine der zwei Ebenen des mindestens einen Justiermarkierungsfeldes auf der Substrathalteroberfläche liegt. In anderen Worten wird eine Ebene des Justiermarkierungsfeldes durch die Substrathalteroberfläche gebildet. Die Justiermarken können dabei teilweise in den Substrathalter eingelassen sein beziehungsweise unterhalb der Substrathalteroberfläche angeordnet sein. Auf diese Weise können die Justiermarkierungsfelder besonders einfach und wenig fehleranfällig ausgebildet werden. Zudem können die Justiermarkierungsfelder direkt in den Substrathalter integriert werden.

In einer weiteren bevorzugten Ausführungsform der Vorrichtung ist vorgesehen, dass das mindestens eine Justiermarkierungsfeld in den Substrathalter vollständig eingelassen ist und der zumindest teilweise unterhalb der Substrathalteroberfläche angeordnet ist. In anderen Worten sind die Ebenen in den Substrathalter eingeprägt und haben ein negatives Höhenprofil in Bezug auf die Substrathalteroberfläche. Auf diese Weise können das Justiermarkierungsfeld vorteilhaft in dem Substrathalter eingebettet sein und direkt bei der Herstellung erzeugt werden. Zudem sind die Justiermarkierungsfelder vorteilhaft geschützt.

In einer weiteren bevorzugten Ausführungsform der Vorrichtung ist vorgesehen, dass das Erfassungsmittel zum Auslesen von Ausrichtungsmarkierungen eines Substrates verwendbar ist. Dabei sind die Justiermarkierungsfelder besonders bevorzugt in Bereichen der Substrathalteroberfläche angeordnet, welche typischerweise mit den Positionen Ausrichtungsmarkierungsfeldern des Substrates oder des Substrathalters fluchten. Auf diese Weise kann vorteilhaft das Erfassungsmittel auch die Ausrichtung der Ausrichtungsmarkierungen vornehmen, ohne dabei eine Relativbewegung in x-y-Richtung absolvieren zu müssen. Vielmehr kann das Erfassungsmittel vorteilhaft unbewegt bleiben und die Auslesung mittels einer Fokussierbewegung beziehungsweise einer Verschiebung des Fokusbereiches durchführen.

In einer Ausführungsform der Vorrichtung wird die Vorrichtung gekapselt ausgeführt, sodass zumindest der Substrathalter und die Erfassungsmittel in einer von der Atmosphäre gasdicht und/oder vakuumdicht abschließbaren Anlagenkammer eingebaut werden. Die entsprechenden Hilfsaggregate beinhalten beispielsweise Zugänge, Schleusen, Pumpen, Sensoren, Sichtfenster, Gasversorgungen und Temperaturregelungen. In dieser Ausführungsform ist die Anlagenkammer mit Spezialatmosphäre auffüllbar, welche vorzugsweise frei von Wasser beziehungsweise Wasserdampf ist. Weiterhin kann in die Spezialatmosphäre frei von Sauerstoff sein. In einer weiteren Ausführungsform ist die Anlagenkammer mit einem Vakuum, bevorzugt mit einem Hochvakuum, besonders bevorzugt mit einem Ultrahochvakuum beaufschlagbar. Das Vakuum in der Anlagenkammer dieser Ausführungsform beträgt weniger als 1*10E-3 mbar, bevorzugt weniger als 1*10E-5 mbar, besonders bevorzugt weniger als 1*10 -8 mbar, ganz besonders bevorzugt weniger als 5*10E-9 mbar, am aller bevorzugtesten weniger als 1*10E-10 mbar, im idealen Fall weniger als 1*10E-12 mbar.

In einer bevorzugten Ausführungsform des Verfahrens ist vorgesehen, dass das Justieren des Erfassungsmittels in Schritt ii) die folgenden Schritte mit dem folgenden Ablauf aufweist:
a) Erfassung einer ersten Justiermarke einer ersten Ebene des Justiermarkierungsfeldes,
b) Erfassung einer zweiten Justiermarke einer zweiten Ebene des Justiermarkierungsfeldes,
c) Ermittlung eines Keilfehlers zwischen dem Erfassungsmittel und dem Substrathalter,
d) Ausgleichung des in Schritt c) ermittelten Keilfehlers,
wobei die erste Ebene und die zweite Ebene zueinander parallel angeordnet sind, und wobei die erste Ebene und die zweite Ebene einen Abstand zueinander aufweisen.

Mit dem Verfahren kann, vorteilhaft ohne einen Referenzwafer oder ein anderes zusätzliches Messsystem, eine Justierung des Erfassungsmittels durchgeführt beziehungsweise ein Keilfehler ausgeglichen werden. Diese Form der Kalibrierung kann immer wieder zwischen Wafer-Bond Prozessen erfolgen ohne dass Erfassungsmittel verfahren werden müssen. Zudem können die Erfassungsmittel vorteilhaft unbewegt bleiben und lediglich einen Fokuswechsel beziehungsweise eine Fokusbereichsverschiebung zum Erfassen der Justiermarken verschiedener Ebenen eines Justiermarkierungsfeldes durchführen.

In einer bevorzugten Ausführungsform der Vorrichtung weist das Justiermarkierungsfeld weitere Justiermarken in einer dritten Ebene auf, welche vorzugsweise ebenfalls parallel zu den anderen Ebenen in einem bestimmten Abstand angeordnet ist. Dabei sind besonders bevorzugt die unterschiedlichen in der z-Ebenen versetzen Justiermarken unterschiedlicher Ebenen für unterschiedliche Wellenlängen transparent, sodass eine weitere beliebige Justierungsmarke in einer beliebigen Ebene des Justierungsmarkierungsfeldes ohne Hindernis durch das Erfassungsmittel erfassbar ist.

Bei einer Erfassung einer Justierungsmarke und einer anschließenden Erfassung einer darüber angeordneten Justierungsmarke, kann somit die jeweilige bekannte Lage beziehungsweise der Abstand zwischen den Ebenen der Justierungsmarken mit dem erfassten Messwert verglichen werden. Da die Beschaffenheit und die Strukturen sowie die Lagen des Justierungsmarkierungsfeldes bevorzugt bekannt ist, kann somit der bekannte Abstand zwischen den Justierungsmarken erfasst und zur Korrektur von optischen Erfassungsmitteln verwendet werden. Anhand dieses bekannten Abstands kann beispielsweise durch eine Relativbewegung der optischen Erfassungsmittel zum ortsfesten Justierungsmarkierungsfeld des Substrathalters eine Justierung und/oder Korrektur des Erfassungsmittels anhand der übereinander angeordneten Justierungsmarken vorgenommen werden, ohne dass eine Bewegung des Substrathalters notwendig ist. Auf diese Weise kann ein optisches Erfassungsmittel besonders genau in zumindest eine Richtung ausgerichtet werden, da der bekannte Abstand und räumliche Position zwischen den übereinander angeordneten Justierungsmarken erfasst wird und somit die tatsächliche Position und Winkellage des jeweiligen optischen Erfassungsmittel errechnet werden kann.

Die Lage der unterschiedlichen Justiermarkierungsfelder zueinander ist bevorzugt ebenfalls bekannt, so dass die Lage sämtlicher Justiermarken des Substrathalters bekannt sind. Dabei sind die Justierungsmarkierungsfelder auf einem Substrathalter bevorzugt im Randbereich der insbesondere runden Substrathalteroberfläche positioniert. In anderen Worten sind die Justiermarkierungsfelder in bestimmten Regionen geclustert, insbesondere in Bereichen, in welchen später typischerweise Ausrichtungsmarkierungen fluchtend bei einer Bearbeitung des Substrates angeordnet sind. Die Justierungsmarkierungsfelder befinden also sich bevorzugt auf dem Substrathalter in räumlich verteilten Positionen an den Stellen, wo sich die auszurichtenden und die zu fügenden Substrate die Ausrichtungsmarken beinhalten. So kann die Position und räumliche Ausrichtungslage des jeweiligen optischen Erfassungsmittel relativ zum Substrathalter errechnet werden und Abweichungen von der idealen Position als Korrekturwerte für das Fügen eines oberen Substrats zum unteren Substrat verwendet werden.

Der Substrathalter weist bevorzugt eine ebene Substratauflagefläche auf. Dabei besteht die Substratauflagefläche des Substrathalters aus einer Vielzahl von insbesondere gleichmäßig verteilten Auflagepunkten und/oder Noppen.

In einer weiteren Ausführungsform des Substrathalters besitzt die Substratauflagefläche eine einstellbare Form, welche in Abhängigkeit des jeweiligen befestigten Substrats eingestellt werden kann. Die Lage der jeweiligen Justiermarken ist dabei weiterhin bekannt.

Zudem befinden sich die Justierungsmarkierungsfelder zur Substratauflagefläche abgesetzt und bevorzugt regelmäßig versetzt zwischen den Auflagepunkten, sodass das Substrat nicht mit den Justierungsmarkierungen in Berührung kommt.

In einer besonders vorteilhaften Ausführungsform des Substrathalters befindet sich eine Justierungsmarkierung und zumindest eine weitere Justierungsmarkierung im Verfahrbereich eines optischen Erfassungsmittels und eines weiteren optischen Erfassungsmittels. Eine noch zielgenauere Justierung der Erfassungsmittel wird somit ermöglicht.

Eine Justierung des Erfassungsmittels zum Substrathalter dient dazu, eine Fehlerkomponente, welche durch die Positionsfehler und/oder Winkelfehler eines Erfassungsmittels das Ergebnis einer Substratausrichtung insbesondere beim Fusionsbonden zu eliminieren oder zumindest zu reduzieren. Durch die Bestimmung der Ausrichtung des Erfassungsmittels zum Substrathalter und der entsprechenden Justierung können Fehler (Parallaxenfehler) um Größenordnungen reduziert werden. Weiterhin werden Korrekturwerte bei der Ausrichtung von zu fügenden Substraten angewendet, um den Ausrichtungsfehler der Substrate zueinander weiter zu minimieren.

Durch die übereinander angeordneten Justierungsmarken und die somit bereitgestellte zusätzliche Höheninformation kann somit vorteilhaft eine Justierung des Erfassungsmittels ohne eine zusätzliche Bewegung des Substrathalters erfolgen, denn jede Bewegung wird mit einer parasitären Bewegung überlagert, die letztendlich den Ausrichtungsfehler vergrößern kann. Dabei werden die gemessenen Positionen einer Justierungsmarke und einer weiteren Justierungsmarke (einer anderen Ebene) mit den tatsächlichen, gespeicherten Werten verglichen. Aus dem Höhenunterschied und dem ebenen Versatz lässt sich ein Positionierfehler bestimmen, welcher korrigiert werden kann.

In dem Justierungsmarkierungsfeld sind vorzugsweise mehrere Justierungsmarken nebeneinander in der jeweiligen Ebene angeordnet. Es wird somit mindestens eine erste Justierungsmarke beziehungsweise mindestens eine zweite Justierungsmarke der entsprechenden Ebene erfasst. Weiterhin ist das Justierungsmarkierungsfeld zwischen den Ebenen vorzugsweise transparent für die Erfassungsmittel ausgebildet, so dass die übereinander angeordneten Justierungsmarken erfassbar sind. Denkbar ist auch, dass die Justierungsmarken der ersten Ebene versetzt zu den Justierungsmarken der zweiten Ebene angeordnet sind und das Justierungsmarkierungsfeld unterschiedliche Abstufungen aufweist.

Zudem kann das Erfassungsmittel neben einer Justierungsmarke einer bestimmten Ebene auch weitere Justierungsmarken der bestimmten Ebene erfassen, solange diese in dem Fokusbereich angeordnet sind. Selbiges gilt ebenfalls für die weiteren Ebenen. Dabei ist das Erfassungsmittel bevorzugt so ausgebildet, dass mehrere Justierungsmarken, insbesondere nebeneinander angeordnete Justierungsmarken der jeweiligen Ebene erfassbar sind. Dadurch wird die Genauigkeit der Ermittlung des Keilfehlers weiter erhöht und eine Justierung des Erfassungsmittels ist noch effektiver ausführbar.

Bei einer weiteren Ausführungsform eines Justierungsmarkierungsfeldes können die einzelnen Justierungsmarken als 3D-Strukturen mit definierten Ecken und/oder Kanten ausgeführt sein, wobei die einzelnen Positionsmerkmale mit einer eindeutigen Kodierung (Informationsgehalt) versehen sind, sodass eine eindeutige Zuordnung der Ecken und/oder Kanten und/oder Stufen zu den 3D-Positionsinformationen ermöglicht ist und eine vollständige räumliche Kartierung des Substrathalters mit dem Justierungsmarkierungsfeld ermöglicht wird.

Bevorzugt wird eine Justierungsmarke des Justierungsmarkierungsfeldes in einer Position erfasst, in welcher in einem weiteren Verfahren eine Ausrichtungsmarkierung eines Substrates positioniert wird. Als Folge der Positionierungsbewegungen und Justierung und/oder Korrektur müssen weder der Substrathalter noch das zumindest eine Erfassungsmittel bewegt, umpositioniert werden. Durch die fixierten Positionen wird die Genauigkeit der Substratausrichtung und dann des Bondes erhöht.

Die Erfassungseinheit weist vorzugsweise Fokussierungsmittel, vorzugsweise ein Objektiv, auf, welches die erste Justierungsmarke bei der Erfassung fokussiert beziehungsweise scharf stellt. Dabei nimmt die Erfassungseinheit beziehungsweise das Objektiv eine Fokusposition ein, in welcher die Erfassungseinheit einen bestimmten Fokusbereich erfassen kann. Der Fokusbereich einer bestimmten Fokusposition der Erfassungseinheit beziehungsweise des Objektivs ist somit fokussiert und innerhalb des Fokusbereiches angeordnete Justierungsmarken erfassbar. Bei einer Erfassung sind vorzugsweise nur Justierungsmarken der jeweiligen Ebene erfassbar beziehungsweise identifizierbar, da ein Fokusbereich bei der Erfassungseinheit jeweils nur genau eine Ebene beinhaltet. Der Abstand zwischen der ersten Ebene und der zweiten Ebene ist somit vorzugsweise größer als die Tiefe des Fokusbereiches, bevorzugter wenigstens doppelt so groß oder größer.

Zur Fokussierung können insbesondere Flüssiglinsen mit veränderbarer Krümmung und/oder schnell umschaltende, in Resonanz betriebene Flüssiglinsen zur gleichzeitigen Abbildung mehreren Fokusebenen ebenfalls verwendet werden. Es ist ebenfalls denkbar, den Brechungsindex der Linse zu verändern, um die Fokussierung und/oder für die Refokussierung durchzuführen. Die aufgeführten Methoden sind gleichwertige oder bessere technische Lösungen zur klassischen Fokussierung und/oder Refokussierung mittels Veränderung der Abstände im optischen Pfad.

Im Anschluss an das Erfassen der ersten Justierungsmarke der ersten Ebene wird die Position des Erfassungsmittels fixiert. Somit wird insbesondere der Fokusbereich festgelegt, so dass die Erfassungseinheit im Folgenden vorzugsweise nur noch Justierungsmarken innerhalb des festgelegten Fokusbereiches erfassen kann. Danach wird durch eine Refokussierung senkrecht zu der ersten Ebene des Justierungsmarkierungsfeldes auf der Substrathalteroberfläche des Substrathalters die zweite Ebene erfasst. Die Erfassungseinheit wird zumindest so weit bewegt, bis die Erfassungseinheit die zweite Justierungsmarke in der zweiten Ebene des Justierungsmarkierungsfeldes erfassen kann. Insoweit wird durch die Fokussierbewegung der Erfassungseinheit vorteilhaft die Erfassungseinheit um den Abstand, welcher zur Scharfstellung benötigt wird, bewegt. Ausrichtungsfehler aufgrund einer globalen Repositionierung der Erfassungseinheit und/oder des fixierten Substrathalters können somit vorteilhaft verhindert werden. Durch die bekannte Topographie sowie eineindeutige und a-priori bekannte x-y-z-Positionen der einzelnen Justierungsmarken in den Justierungsmarkierungsfelder auf dem Substrathalter kann durch die tatsächliche Fokussierbewegung und Vermessung insbesondere der Winkelfehler der Erfassungseinheit an den vermessenen Justierungsmarken errechnet werden.

Dazu werden die gemessenen Werte, insbesondere der gemessene Abstand der unterschiedlichen Ebenen der Justierungsmarken sowie eine laterale Verschiebung und/oder Verdrehung mit den gespeicherten idealen Werten, welche die Annäherungen der jeweiligen wahren Werte sind, verglichen und der Unterschied als Korrekturwert für weitere Messungen verwendet.

Sind zwischen der ersten Ebene und der zweiten Ebene weitere Justierungsmarken in weiteren Ebenen angeordnet, können diese bei der Fokussierbewegung der Erfassungseinheit von der Erfassungseinheit vermessen werden, so dass das Bewegen der Erfassungseinheit besonders genau und kontrolliert durchführbar ist. Weiterhin kann durch mehrere erfasste Justierungsmarken, deren Lagen im Justierungsmarkierungsfeld bekannt sind, die relative Ausrichtung und die Bestimmung der Korrekturwerte noch genauer erfolgen.

Die Justierungsmarken weisen bevorzugt eine Information bezüglich ihrer jeweiligen Lage innerhalb des Justierungsmarkierungsfeldes auf. Dabei ist neben der Lage entlang des Justierungsmarkierungsfeldes (x-y-Lage) auch die jeweilige Höhe beziehungsweise der Abstand der Ebenen zueinander bekannt. Wird somit die erste Justierungsmarke erfasst, kann vorteilhaft festgestellt werden, in welcher Ebene diese angeordnet ist. Insbesondere wenn ein Justierungsmarkierungsfeld mehr als zwei Ebenen mit unterschiedlichen Abständen zueinander aufweist, kann somit die Ausrichtung und Fokussierung einfacher gesteuert oder geregelt werden, da die jeweilige Höheninformation bezüglich der Justierungsmarke erfasst wird. Beispielsweise kann bei einer kontinuierlichen Erfassung bei dem Bewegen oder bei der Erfassung der ersten Justierungsmarke vorteilhaft festgestellt werden, welche Position in welcher Ebene beziehungsweise Stufe im Fokusbereich erfasst wird. Wird zudem eine Position zwischen zwei Ebenen beziehungsweise Stufen erfasst, kann vorteilhaft eine darüber oder darunter angeordnete Ebene beziehungsweise Stufe angefahren werden. Weiterhin kann vorteilhaft die Lage in x-y-Position erfasst und kontrolliert werden.

Die Vorrichtung ist bevorzugt so ausgebildet, dass die Fokusposition der Erfassungseinheit unmittelbar nach einem Erfassen der ersten Justierungsmarke der ersten Ebene des Justierungsmarkierungsfeldes fixierbar ist. Die fixierte Fokusposition der Erfassungseinheit legt dabei den scharf abgebildeten Fokusbereich fest. Auf diese Weise kann durch die Bewegungseinrichtung vorteilhaft der Abstand der ersten Ebene zur zweiten Ebene angefahren und somit fokussiert werden. Die Erfassungseinheit wird zudem insbesondere lateral ortsfest gehalten, so dass lediglich durch das Erfassen der Justierungsmarken ein Bewegen des Erfassungsmittels in eine z-Richtung der Abstand zwischen den Ebenen angefahren werden. Eine direkte Sichtkontrolle durch genau eine Erfassungseinheit kann somit vorteilhaft eine korrekte Ausrichtung des Erfassungsmittels zum Substrathalter verifizieren.

In einer möglichen Ausführungsform der Vorrichtung zur Justierung eines Erfassungsmittels ist vorgesehen, dass das mindestens eine Justierungsmarkierungsfeld auf einer der Substrathalteroberfläche abgewandten Rückseite des Substrathalters angeordnet ist. Das Justierungsmarkierungsfeld kann beispielsweise auf der Rückseite angebracht oder in den Substrathalter eingelassen sein. Zudem kann das Justierungsmarkierungsfeld auch durch den Substrathalter selbst gebildet werden. Vorteilhaft kann die Erfassungseinheit auf der Substrathalteroberfläche abgewandten Rückseite angeordnet werden.

In einer bevorzugten Ausführungsform der Vorrichtung zur Justierung eines Erfassungsmittels ist vorgesehen, dass ein Mittelpunkt des Justierungsmarkierungsfeldes zumindest teilweise mit einem Mittelpunkt der Substrathalteroberfläche fluchtet. Durch die mittige Anordnung des Justierungsmarkierungsfeldes kann vorteilhaft die Justierung des Erfassungsmittels zu dem Substrathalter vorteilhaft genau ausgeführt werden. In dieser Ausführungsform kann zudem vorteilhaft eine lineare Fehlerkomponente oder eine Rotation der Erfassungseinheit relativ zum Substrathalter wahrgenommen werden.

Bevorzugt weist das Justierungsmarkierungsfeld zumindest drei Ebenen mit Justierungsmarken auf. Dabei wird auf den Justierungsmarken die Information bereitgestellt, auf welcher Ebene diese angeordnet sind. Weiterhin können auf diese Weise mehrere bestimmte Abstände durch die Vorrichtung angefahren werden, sodass mehrere Fokuspositionen und damit definierte Abstände zwischen dem Erfassungsmittel und Substrathalter bei der Justierung eingestellt werden können. Die Abstände zwischen den Ebenen können gleich groß sein. Bevorzugt sind die Ebenen jedoch in unterschiedlichen Abständen zueinander angeordnet. Auf diese Weise können flexibel mehrere Abstände angefahren werden. Die Einstellung von unterschiedlichen Fokussierebenen, daraus folgend die Einstellung von bestimmten, unterschiedlichen Relativabständen zwischen des Erfassungsmittels und dem Substrathalter kann bei unterschiedlich dicken Substraten vorteilhaft sein.

In einer bevorzugten Ausführungsform der Vorrichtung zur Justierung eines Erfassungsmittels ist vorgesehen, dass die Vorrichtung mindestens ein weiteres Justierungsmarkierungsfeld und mindestens eine weitere Erfassungseinheit zum Erfassen des mindestens einen weiteren Justierungsmarkierungsfeldes aufweist, wobei das mindestens eine weitere Justierungsmarkierungsfeld ortsfest zu dem Substrathalter angeordnet ist. Die Kombination mehrerer Messwerte in Bezug auf das weitere Justierungsmarkierungsfeld erlaubt eine noch genauere Ausrichtung, da an die Erfassung an mehreren Punkten erfolgt. Beispielsweise können auf diese Weise Verschiebungen und/oder Rotationsfehler erkannt werden. Das Justierungsmarkierungsfeld und das mindestens eine Justierungsmarkierungsfeld sind dabei vorzugsweise entlang des Substrathalters versetzt angeordnet. Besonders bevorzugt weist die Vorrichtung insgesamt drei Justierungsmarkierungsfelder und drei Erfassungseinheiten auf, welche jeweils um einen Mittelpunkt der Substrathalteroberfläche verteilt, insbesondere in radialer Richtung gleichmäßig zueinander versetzt angeordnet sind.

Justierungsmarkierungen können jegliche, zueinander ausrichtbare Objekte wie Kreuze, Kreise oder Quadrate oder propellerartige Gebilde oder Gitterstrukturen, insbesondere Phasengitter für den Ortsfrequenzbereich sein. Weiterhin sind 3D-Objekte wie Pyramiden, Kegel, Stufen als Justierungsmarkierungen verwendet werden.

In einer besonders vorteilhaften Ausführungsform der Vorrichtung können Justierungsmarkierungen zumindest teilweise QR-Code beinhalten, welche insbesondere eine absolute, maschinenlesbare Positionskodierung (x, y, z-Position) der jeweiligen Justierungsmarke beschreiben, sodass eine vollständige Kartierung des Substrathalters und/oder der Substrathalteroberfläche mit den Justierungsmarkierungsfelder vor der Verwendung des Substrathalters erstellt werden, um als Referenzwerte für alle Justierungsvorgänge zu dienen.

In einer weiteren besonders vorteilhaften Ausführungsform können Justierungsmarkierungen zumindest teilweise alphanumerischen Zeichen beinhalten, welche insbesondere eine absolute, maschinenlesbare Positionskodierung (x, y, z- Position) der jeweiligen Justierungsmarke beschreiben. Die alphanumerischen Zeichen können bevorzugt auch vom Operator gelesen werden.

Die Justierungsmarkierungen und/oder Justierungsmarkierungsfelder werden mit Vorzug mittels elektromagnetischer Strahlung bestimmter Wellenlänge und/oder Wellenlängenbereiche erfasst. Diese umfassen beispielsweise Infrarotstrahlung, sichtbares Licht oder ultraviolette Strahlung. Die Verwendung von Strahlung kürzerer Wellenlänge, wie EUV (extrem ultraviolette Strahlung) oder Röntgenstrahlung ist ebenfalls möglich.

Das Justierungsmarkierungsfeld besteht aus beziehungsweise umfasst somit positionskodierten und höhenkodierten Justierungsmarkierungen, welche eine eindeutige Positionsinformationen und Höheninformationen des Substrathalters zur Justierung der Erfassungsmittel liefern.

In einer Ausführungsform ist die Größe beziehungsweise die Dimensionierung des Justierungsmarkierungsfeldes in x-y-Richtung an den Fokusbereich des insbesondere optischen Erfassungsmittel angepasst, sodass jeweils mindestens zwei Stufen oder Ausrichtungsmarkierungsebenen betrachtet werden können.

Die Anzahl der Stufen und die Gesamthöhe des Justierungsmarkierungsfeldes ist dabei vorzugsweise auf den Abstand, welcher eingestellt werden soll, abgestimmt. Soll beispielsweise ein Fokussierabstand von mindestens 500 Mikrometer eingestellt werden, werden bevorzugt 550 Mikrometer höhenkodierte Positionsinformation im Justierungsmarkierungsfeld abgebildet, um eindeutig den Abstand anfahren zu können.

Die Erfassung erfolgt bevorzugt mit entsprechenden abbildenden optischen Systemen, sodass die Abbildungstiefe so gewählt werden kann, dass diese geringer ist als die Stufenhöhe oder eine Schichtdicke des Justierungsmarkierungsfeldes. Die Abbildungstiefe (eng: depth of focus, DOF) ist derjenige Bereich im Bildraum eines abbildenden optischen Systems, in dem ein hinreichend scharfes Bild eines fokussierten Objektes, insbesondere einer Ausrichtungsmarkierung oder einer Justierungsmarkierung entsteht. Im Umkehrschluss bedeutet dies, dass die Bildebene (ein Bilderfassungsmittel, Sensor) im Bereich der Abbildungstiefe verschoben werden kann, ohne dass das Bild eines Objektes merklich unscharf wird.

Erfolgt die Erfassung einer Justierungsmarke des Justierungsmarkierungsfeldes mit einer geringen Abbildungstiefe, welche kleiner ist als die Stufenhöhe, bevorzugt kleiner ist, als die halbe Stufenhöhe, besonders bevorzugt kleiner ist, als 0,1 Stufenhöhe, kann eindeutig die Position des Justierungsmarkierungsfeldes insbesondere in der z-Richtung bestimmt werden.

Die Abbildungstiefe der Erfassungsmittel beträgt weniger als 50 Mikrometer, bevorzugt weniger als 20 Mikrometer, besonders bevorzugt weniger als 10 Mikrometer, ganz besonders bevorzugt weniger als 5 Mikrometer, im optimalen Fall weniger als 4 Mikrometer.

Wenn hingegen die Abbildungstiefe ausreicht, um mindestens zwei Stufenhöhen scharf abzubilden, wird die Positionierungsunsicherheit der Vorrichtung erhöht, denn damit kann keine eindeutige Zuordnung einer z-Höhe zu einer Stufe erfolgen.

In einer bevorzugten Ausführungsform der Vorrichtung kann ein Bilderfassungsmittel beziehungsweise ein Erfassungsmittel der Erfassungseinheit um 0,2 Stufenhöhen ohne bildseitige Refokussierung reproduzierbar verschoben werden. Dies kann dazu verwendet werden zu bestimmen, welche Ausrichtungsmarkierung des Justierungsmarkierungsfeldes für die Positionierung verwendet werden sollen, wenn die bildseitige Fokusebene direkt auf der Höhe zwei angrenzender Stufen liegt und beide Stufen gleich scharf erscheinen. Es kann mit der geringen Verschiebung des Bilderfassungsmittels eine Entscheidung (auch als ein rechnerimplementiertes, eigenständiges Verfahren) der zu verwendenden Justierungsmarkierungen getroffen werden.

Physikalisch bedingt wird bei der Erfassung des Justierungsmarkierungsfeldes insbesondere jeweils nur eine Ebene beziehungsweise Stufe scharf abgebildet. Insoweit liegt bevorzugt jeweils nur eine Stufe beziehungsweise Ebene im Fokusbereich der Erfassungseinheit. Da die Justierungsmarkierungen des Justierungsmarkierungsfeldes positions- und ortskodiert sind, kann aus einer scharf erfassten Justierungsmarke einer Ebene eine Positionsinformation insbesondere des Substrathalters in einem räumlichen Koordinatensystem und/oder des Erfassungsmittels bestimmt werden. Durch die Refokussierung des Erfassungsmittels auf eine weitere Justierungsmarkierung wird durch die Größen der bekannten Stufenhöhe und aus dem gemessenen ebenen Versatz der Justierungsmarken insbesondere der Winkelfehler des Erfassungsmittels bestimmt, welche als Korrekturwert für die Ausrichtung eines Substratstapels verwendet werden kann.

Das Verfahren zur Justierung erhöht die Ausrichtungsgenauigkeit insbesondere mittels der Bereitstellung von Korrekturwerten für lokalen Winkelfehler von Erfassungseinheiten, welche mit weiteren Justierungsmarkierungsfeldern und entsprechenden weiteren Erfassungseinheiten erfasst und zur Steuerung und/oder Regelung der Ausrichtung verwendet werden.

Hierfür weist die Vorrichtung zur Justierung und zum Ausrichten von Substraten und zum Bonden von Substraten bevorzugt eine, insbesondere softwaregestützte, Steuerungseinheit auf, mittels der die hier beschriebenen Schritte durchgeführt und Bauteile gesteuert werden. Dabei sollen geschlossene Regelkreise sowie Regelungen unter der Steuerungseinheit subsummiert verstanden werden.

Mit X- und Y-Richtung oder X- und Y-Position werden in einem X-Y-Koordinatensystem beziehungsweise in einer beliebigen Z-Ebene des X-Y-Koordinatensystems verlaufende Richtungen oder angeordnete Positionen verstanden. Die Z-Richtung ist zu den X-Y-Richtungen orthogonal angeordnet. Die X- und Y-Richtung entspricht insbesondere einer lateralen Richtung, vorzugsweise entlang der Ebenen des Justierungsmarkierungsfeldes beziehungsweise entlang der Substrathalteroberfläche. Die Z-Richtung ist vorzugsweise die Richtung, in welche das Erfassungsmittel bewegt wird, wenn die Fokusposition der Erfassungseinheit in der X-Y-Ebene fixiert wird.

Positionsmerkmale werden aus den Positions- und/oder Lagewerten der Justierungsmarkierungen auf dem Substrathalter, insbesondere durch die Erfassung und Auswertung des Justierungsmarkierungsfeldes berechnet beziehungsweise erfasst.

Das Justierungsmarkierungsfeld befindet sich vorzugsweise in örtlicher Nähe zu den Ausrichtungsmarkierungen der Substrate. Besonders bevorzugt ist zumindest eine Ausrichtungsmarkierung der Substrate und das Justierungsmarkierungsfeld auf dem Substrathalter ohne laterale Repositionierung des Erfassungsmittel erfassbar angeordnet. Auch kann ein insbesondere zusätzliches Ausrichtungsmarkierungsfeld auf der Rückseite des Substrathalters angeordnet sein, welche sowohl für die Justierung eines zusätzlichen Erfassungsmittels als auch für die Ausrichtung des Substratstapels mittels korrelierter Positionen verwendet werden kann.

In einer besonders bevorzugten Ausführungsform befindet sich zumindest ein Ausrichtungsmarkierungsfeld vorzugsweise in z-Richtung fluchtend zu den zusätzlichen Justierungsmarkierungen der Substrate, vorzugsweise auf einer Rückseite des Substrathalters.

In einer weiteren bevorzugten Ausführungsform der Vorrichtung befindet sich zumindest ein Justierungsmarkierungsfeld vorzugsweise in z-Richtung fluchtend zum Zentrum des Substrates beziehungsweise zu dem Mittelpunkt der Substrathalteroberfläche, insbesondere auf einer Rückseite des Substrathalters.

In einer weiteren bevorzugten Ausführungsform der Vorrichtung befinden sich zwei Justierungsmarkierungsfelder vorzugsweise jeweils fluchtend in z-Richtung zu den Justierungsmarkierungen des Substrathalters, insbesondere an einer Rückseite des Substrathalters.

In einer weiteren bevorzugten Ausführungsform der Vorrichtung befindet sich zumindest ein Justierungsmarkierungsfeld auf der Substratseite des Substrathalters beziehungsweise auf der Seite der Substrathalteroberfläche, in der Nähe des Substrates, für die optische Erfassung zugänglicher Position. Diese zusätzlichen Erfassungsmittel können in einem ersten Verfahren zum Substrathalter ausgerichtet werden und in einem zweiten Verfahren zur Ausrichtung von Substraten als zusätzliche Erfassungsmittel verwendet werden.

Eine weiterführende Ausführungsform der Vorrichtung beinhaltet mindestens zwei Justierungsmarkierungsfelder auf der Substratseite des Substrathalters in der Nähe des Substratrandes, für die optische Erfassung zugänglicher Position. Somit kann vorteilhaft eine Nivellierung des Substrathalters durchgeführt werden.

Das Verfahren zum Ausrichten und die Vorrichtung zum Ausrichten weisen insbesondere mindestens eine zusätzliche Erfassungseinheit mit einem entsprechenden Mess- und/oder Regelsystem und mindestens ein zusätzliches Justierungsmarkierungsfeld und/oder Ausrichtungsmarkierungsfeld auf, wobei durch zusätzliche Messwerte und Korrelationen mit mindestens einem der Messwerte der zusätzlichen Erfassungseinheiten die Ausrichtungsgenauigkeit weiter erhöht wird. Dazu werden die jeweiligen Korrekturwerte aus den Messungen angewendet.

Bei einem weiteren Verfahren nach der Justierung der Erfassungsmittel bei der Verwendung der Korrekturen wird durch die Korrelation mindestens einer der vermessenen zusätzlichen Ausrichtungsmarkierungen, insbesondere auf den Kontaktflächen eines ersten Substrats und/oder zweiten Substrats mit zumindest einer Justierungsmarke des Justierungsmarkierungsfeldes, welche auch bei der Ausrichtung der Substrate frei zugänglich und sichtbar ist, wird die direkte Beobachtbarkeit einer Justierungsmarke und somit eine Echtzeitmessung und Regelung während der Ausrichtung ermöglicht. Somit steigt zusätzlich die Ausrichtungsgenauigkeit der Substrate.

In einer weiteren Ausführungsform der Vorrichtung ist mindestens ein weiteres Justierungsmarkierungsfeld auf der Substratseite eines Substrathalters Nahe des Umfangsrandes des Substrats in einer Position, welche dauerhaft für eine weitere Erfassungseinheit zugänglich ist, positioniert. Besonders bevorzugt befindet sich eine Oberfläche des Justierungsmarkenfeldes in derselben Ebene, wie die zu bondende Oberfläche des auf dem Substrathalter befestigten Substrats.

Durch die zusätzlich hinzugefügten 3D-Positionsmerkmale am Substrathalter, die eindeutig mit den Positionsmerkmalen auf dem Substrat korrelierbar sind, kann eine direkte Beobachtung der Ausrichtungsmarkierungen auf dem Substrat durch eine direkte Beobachtung der Justierungsmarkierung am Substrathalter ersetzt werden. Dies hat den Vorteil, dass der beobachtbare Teil des Substrathalters praktisch immer im Sichtfeld beziehungsweise in einem Erfassungsbereich einer Erfassungseinheit angeordnet werden kann. Durch die 3D-Positionsinformation und Korrektur der Winkellage der Erfassungsmittel kann die Ausrichtung der Substrate zueinander mit erhöhter Genauigkeit durchgeführt werden.

Bevorzugt beträgt ein Erfassungsbereich einer Erfassungseinheit eine Fläche kleiner 3 mm x 3 mm, bevorzugt kleiner 2 mm x 2 mm, besonders bevorzugt kleiner 1 mm x 1 mm.

Eine aktive Rückführung der Daten für die Positionierung und Positionskorrektur erhöht die Genauigkeit im Vergleich zu einer gesteuerten Positionierung im Stand der Technik, da in geschlossenen Regelkreisen eine Kontrollmöglichkeit des Ist-Standes der Position gegeben ist.

Es wird eine Korrelation der Ausrichtungsmarkierungen eines ersten Substrats und/oder eines zweiten Substrats auf der jeweiligen Kontaktflächen der Substrate mit zumindest einer Justierungsmarke des Justierungsmarkierungsfeldes hergestellt. Die eine Justierungsmarke des Justierungsmarkierungsfeldes ist während der Ausrichtung, insbesondere direkt, durch die Erfassungseinheit erfassbar.

Die direkte Erfassbarkeit beziehungsweise Beobachtbarkeit der mindestens einer zusätzlichen Justierungsmarke eines zusätzlichen Justierungsmarkierungsfeldes ermöglicht eine Echtzeitmessung der 3D-Position des Substrathalters bzw. der Erfassungsmittel. Dieselbe Vorrichtung kann beim Ausrichten von Substraten beziehungsweise beim Bonden, insbesondere Fusionsbonden von Substraten zur Reduktion von Ausrichtungsfehlern verwendet werden. Dabei wird die Ausrichtungsgenauigkeit erhöht, weil mit der Erfassung des Justierungsmarkierungsfeldes sowie durch Bereitstellung von Korrekturwerden und der errechneten Höheninformation Positionierunsicherheiten wegfallen, wodurch die Fehlerfortpflanzung reduziert wird. Durch diese Maßnahme wird die Ausrichtungsgenauigkeit durch die Reduzierung der Anzahl der notwendigen Zustellbewegungen und geregelte Höhenverstellung beim Bonden verbessert.

Die Erfassungseinheit zur Erfassung des Justierungsmarkierungsfeldes ist insbesondere Teil eines optischen Systems zur Erfassung des Justierungsmarkierungsfeldes und beinhaltet gemäß einer vorteilhaften Ausführungsform Strahlformungs- und/oder Umlenkungselemente wie Spiegel, Linsen, Prismen, Strahlungsquellen insbesondere zur Köhlerschen Beleuchtung sowie Bilderfassungsmittel wie Kameras (CMOS-Sensoren, oder CCD, oder Flächen- oder Zeilen- oder Punkterfassungsmittel wie ein Fototransistor) und Bewegungsmittel zur Fokussierung sowie Auswertemittel zur Regelung des optischen Systems.

In einer weiteren Ausführungsform der Vorrichtung kann das optische System in Kombination mit einem Rotationssystem für die Substratpositionierung nach dem Prinzip der Umschlagsjustierung verwendet werden (vgl. dazu Hansen, Friedrich: Justierung, VEB Verlag Technik, 1964, Abs. 6.2.4, Umschlagmethode). Demnach wird bei der Umschlagsjustierung mindestens eine Messung in einer definierten Position des jeweiligen Substrathalters und mindestens eine Messung in 180 Grad gedrehter, entgegengesetzt orientierter, umgeschlagener Position durchgeführt. Das so erhaltene Messergebnis ist insbesondere von Exzentrizitätsfehlern bereinigt. Bevorzugt kann dabei der Substrathalter rotiert werden und die Erfassungsmittel bleiben bis auf eine Fokussierung ortsfest fixiert.

Eine Weiterbildung der Vorrichtung zur Justierung kann als Vorrichtung zum Ausrichten von Substraten verwendet werden.

Weiterhin kann eine Vorrichtung ein System zur Herstellung von Pre-bonds beinhalten. Dazu können für das Fügen von Substraten Druckstäbe (engl. Pin) und/oder einstellbare Düsen zur Initiierung des Fusionsbondes verwendet werden. Insbesondere können die einstellbaren Düsen höhenverstellbar sein, sodass die relative Position zur Substratrückseite verändert werden kann und der Volumenstrom der Düse geregelt veränderbar ist. Die Ausrichtung dieser kann vorteilhaft anhand der übereinander angeordneten Justierungsmarkierungen erfolgen.

Weiterhin beinhaltet eine Vorrichtung vorzugsweise Bewegungseinrichtungen mit Antriebssystemen, Führungssystemen, Festhaltungen sowie Messsystemen, um zumindest die Erfassungseinheit und den Substrathalter und damit das auszurichtende Substrat zu bewegen, zu positionieren und genau auszurichten.

Die Bewegungseinrichtungen können jede Bewegung als Resultat von Einzelbewegungen erzeugen, sodass die Bewegungseinrichtungen bevorzugt schnelle, den Genauigkeitsanforderungen nicht entsprechende Grobpositioniervorrichtungen sowie präzise arbeitende Feinpositioniervorrichtungen enthalten können.

Als Grobpositioniervorrichtung wird eine Positioniervorrichtung verstanden, wenn die Anfahr- und/oder Wiederholgenauigkeit vom Sollwert mehr als 0,1%, bevorzugt mehr als 0,05%, besonders bevorzugt mehr als 0,01%, bezogen auf den gesamten Verfahrweg oder Rotationsbereich, bei umlauffähigen Rotationsantrieben eine volle Umdrehung von 360 Grad, abweicht.

Beispielsweise resultiert somit bei einer Grobpositioniervorrichtung mit einem Verfahrweg von über 600 mm (Doppeltes vom Substratdurchmesser) eine Anfahrgenauigkeit von 600 mm * 0,01%, also mehr als 60 Mikrometer als Restunsicherheit.

In anderen Ausführungsformen der Grobpositionierung ist die Restunsicherheit der Anfahr- oder Wiederholgenauigkeit weniger als 100 Mikrometer, bevorzugt weniger als 50 Mikrometer, besonders bevorzugt weniger als 10 Mikrometer. Dabei sollen die thermischen Störgrößen ebenfalls berücksichtigt werden.

Eine Grobpositioniervorrichtung erfüllt die Positionieraufgabe nur dann mit hinreichender Genauigkeit, falls zwischen der tatsächlich erreichten Ist-Position und dem Sollwert der Position die Abweichung im Verfahrbereich einer zugeordneten Feinpositioniervorrichtung liegt.

Eine alternative Grobpositioniervorrichtung erfüllt die Positionieraufgabe nur dann mit hinreichender Genauigkeit, falls zwischen der tatsächlich erreichten Ist-Position und dem Sollwert der Position die Abweichung im halben Verfahrbereich einer zugeordneten Feinpositioniervorrichtung liegt.

Als Feinpositioniervorrichtung wird eine Positioniervorrichtung verstanden, wenn die Restunsicherheit der Anfahr- und/oder Wiederholgenauigkeit vom Sollwert weniger als 500 ppb, bevorzugt weniger als 100 ppb, bevorzugter 1 ppb bezogen auf den gesamten Verfahrweg oder Rotationsbereich nicht überschreitet.

Vorzugsweise wird eine Feinpositioniervorrichtung einen absoluten Positionierfehler kleiner 5 Mikrometer, bevorzugt kleiner 1 Mikrometer, kompensieren.

Die Ausrichtung der Substrate zueinander kann in allen sechs Bewegungsfreiheitsgraden erfolgen: drei Translationen gemäß der Koordinatenrichtungen x, y und z sowie drei Rotationen um die Koordinatenrichtungen. Dabei können die Bewegungen in jeglicher Richtung und Orientierung durchgeführt werden.

Roboter zum Substrathandling werden als Bewegungseinrichtungen subsummiert. Die Festhaltungen können in den Bewegungseinrichtungen bauteilintegriert oder funktionsintegriert sein.

Weiterhin beinhaltet die Vorrichtung zum Justieren der Erfassungseinheit vorzugsweise Regelungssysteme und/oder Auswertungssysteme, insbesondere Rechner, um die beschriebenen Schritte, insbesondere Bewegungsabläufe auszuführen, Korrekturen durchzuführen, Betriebszustände der Vorrichtung zu analysieren und zu speichern.

Verfahren werden vorzugsweise als Rezepte erstellt und in maschinenlesbarer Form ausgeführt. Rezepte sind optimierte Wertesammlungen von Parametern, die im funktionalen oder verfahrenstechnischen Zusammenhang stehen. Die Nutzung von Rezepten erlaubt es, eine Reproduzierbarkeit von Produktionsabläufen zu gewährleisten.

Weiterhin beinhaltet eine Vorrichtung zum Justieren gemäß einer vorteilhaften Ausführungsform Versorgungs- sowie Hilfs- und/oder Ergänzungssysteme (Druckluft, Vakuum, elektrische Energie, Flüssigkeiten wie Hydraulik, Kühlmittel, Heizmittel, Mittel und/oder Vorrichtungen zur Temperaturstabilisierung, elektromagnetische Abschirmung).

Weiterhin kann die Vorrichtung zum Ausrichten Gestelle, Verkleidungen, schwingungsunterdrückende oder -dämpfende oder -tilgende aktive oder passive Subsysteme aufweisen.

Weiterhin beinhaltet eine Vorrichtung zum Ausrichten bevorzugt mindestens ein Messsystem, bevorzugt mit Messeinheiten für jede Bewegungsachse, welche insbesondere als Weg-Messsysteme und/oder als Winkel-Messsysteme ausgeführt werden können. Das Messsystem umfasst bevorzugt mindesten eine Erfassungseinheit oder eine zusätzliche Erfassungseinheit.

Es können sowohl taktile, also tastende oder nicht-taktile Messverfahren verwendet werden. Die Messnormale, die Einheit der Messung kann als physikalisch-körperliches Objekt, insbesondere als ein Maßstab vorliegen oder im Messverfahren implizit vorhanden sein, wie die Wellenlänge der verwendeten Strahlung vorliegen.

Für das Erreichen der Ausrichtungsgenauigkeit kann mindestens eines der folgenden Messsystem ausgewählt und verwendet werden. Messsysteme setzen Messverfahren um. Es können insbesondere
- Induktive Verfahren und/oder
- Kapazitive Verfahren und/oder
- Resistive Verfahren und/oder
- Vergleichsverfahren, insbesondere optische Bilderkennungsverfahren, Erfassung von Positionsmarken und/oder QR-Codes und/oder
- inkrementelle oder absolute Verfahren (mit insbesondere Glasnormale als Maßstab, oder Interferometer, insbesondere Laserinterferometer, oder mit magnetischer Normale) und/oder
- Laufzeitmessungen (Dopplerverfahren, time of flight-Verfahren) oder andere Zeiterfassungsverfahren und/oder
- Triangulationsverfahren, insbesondere Lasertriangulation, und/oder
- Autofokusverfahren und/oder
- Intensitätsmessverfahren wie faseroptische Entfernungsmesser verwendet werden.

Die aufgeführten Messverfahren können zusätzlich in der Vorrichtung zur Justierung verwendet werden, um insbesondere nicht nur die lokale relative Position und/oder Lage des Erfassungsmittels zum Substrathalter zu erfassen und zu korrigieren, sondern eine absolute Positionsmessung in der Vorrichtung durchzuführen.

Weiterhin beinhaltet eine besonders bevorzugte Ausführungsform der Vorrichtung zum Ausrichten mindestens ein Messsystem, welches die X-Y-Z-Position und/oder Ausrichtungslage und/oder Winkellage mindestens eines der Substrate und/oder eines der Substrathalters im Bezug zu einer definierten Referenz, insbesondere zum Gestell erfasst. Das Messsystem umfasst zumindest eine justierte Erfassungseinheit.

Dabei werden mit dem Messsystem beziehungsweise mit der Erfassungseinheit des Messsystems 3D-Positionen bevorzugt des Substrathalters mit korrigierter Winkellage ermittelt, sodass zur ebenen Positionsangaben aus der Messung die Höheninformation und die Winkelstellung ermittelbar ist. Dazu wird zumindest ein Justierungsmarkierungsfeld bestehend aus Stufen und/oder Schichten mit eindeutigen Positionsmarkierungen erfasst.

Als Gestell kann eine, insbesondere aus Naturhartgestein oder Mineralguss oder Kugelgraphitguss oder hydraulisch gebundenem Beton bestehender Teil, welche insbesondere schwingungsgedämpft und/oder schwingungsisoliert und/oder mit Schwingungstilgung aufgestellt ist, verstanden werden.

Durch Anbringung der Erfassungseinheiten an dem Substrathalter und Anbringung von dem Justierungsmarkierungsfeld beispielsweise am Gestell ist eine Umkehrung der Idee ebenfalls vorteilhaft durchführbar. In diesem Fall wird die Erfassungseinheit mit dem Substrathalter bewegt und das Justierungsmarkierungsfeld ist am Gestell fixiert.

Damit eine Erfassung, Auswertung und Steuerung zu einem beliebigen Zeitpunkt, insbesondere dauerhaft, erfolgen kann, werden die Justierungsmarken des Justierungsmarkierungsfeldes gemäß einer vorteilhaften Ausführungsform auf einer größeren Fläche der jeweiligen Ebene als das Blickfeld eines Bilderfassungssystems der Erfassungseinheiten verteilt, um die Steuereinheit (und/oder Regeleinheit), insbesondere kontinuierlich, mit Messwerten zu versorgen. Dabei werden jedoch zu jeder Position im Blickfeld eines Bilderfassungssystems die Justierungsmarken des Justierungsmarkierungsfeldes so ausgelegt, dass die Höheninformation aus dem Justierungsmarkierungsfeld und/oder aus der erweiterten ebenen Positionsinformation erfassbar wird. Mit anderen Worten kann bei jeder lateralen Position des Substrathalters durch die Anordnung der Justierungsmarkierungen des Justierungsmarkierungsfeldes die räumliche Position des Erfassungsmittels erfasst werden und die Korrektur der Winkellage bestimmt werden. Da die relative Position insbesondere des Erfassungsmittel als 3D-Positionsinformation vorliegt, kann eine genauere räumliche Ausrichtung der darauf befestigten Substrate zueinander durchgeführt werden.

Für eine X-Y-Z-Positionsbestimmung kann in der Vorrichtung zum Ausrichten zusätzlich zu dem mindestens einen Erfassungsmittel mindestens ein Dreistrahl-Interferometer mit einem entsprechend ausgebildeten, insbesondere monolithischen, Reflektor für die Erfassung der X-Y-Z-Position- und/oder Lagebestimmung des Substrathalters verwendet werden. Konstruktiv werden dazu die Erfassungsmittel und das Interferometer in eine Baugruppe integriert, sodass das Erfassungsmittel und das Interferometer keine voneinander unabhängigen Bewegungen durchführen.

Eine weitere vorteilhafte Ausführungsform einer Vorrichtung kann insbesondere zusätzlich zur Vorrichtung zur Erfassung von Justierungsmarken eines Justierungsmarkierungsfeldes zusätzlich Messmittel, beispielsweise einen prismatischen, monolithischen Reflektor beinhalten, welcher mit mehreren, insbesondere Dreistrahl-Interferometern vermessen werden. So können die Fehlerfortpflanzung durch Mittelung, Differenzbildung und Messreihenbildung eliminiert und die Ausrichtungsgenauigkeit weiter erhöht werden. Mit anderen Worten können mit hinreichend schnellen Positionsmessungen Regelungssysteme für die Trajektorie der Bewegung verwendet werden, sodass Positionsfehler des Substrathalters weiter reduziert werden können.

Der, insbesondere aus einem monolithischen Block gebildete, Substrathalter der Vorrichtung zum Ausrichten und/oder zur Justierung weist vorzugsweise mindestens zwei der folgenden Funktionen auf:
- Substratbefestigung mit Vakuum (Vakuumbahnen, Anschlüsse), und/oder mit elektrostatischen Mitteln,
- Formkompensation zur Verformung des Substrats mittels mechanischen und/oder hydraulischen und/oder piezoelektronischen und/oder pyroelektrischen und/oder elektrothermischen Betätigungselementen,
- Positions- und/oder Lagebestimmung (Messnormalen, Reflexionsflächen und/oder Prismen, insbesondere die Reflektoren für die Interferometrie, Passmarken und/oder Passmarkenfelder, flächenhaft ausgebildete Messnormalen für Ebenen, Volumennormalen, insbesondere Stufen, Schichtsysteme bekannter Schichthöhen mit Justierungsmarkierungen in Ebenen unterteilt)
- Bewegung (Führungsbahnen).

Bewegungseinrichtungen, die nicht zur Feinjustierung verwendet werden, sind insbesondere als Robotersysteme, vorzugsweise mit inkrementellen Weggebern, ausgebildet. Die Genauigkeit dieser Bewegungseinrichtungen für Hilfsbewegungen wird von der Genauigkeit zur Ausrichtung des Substratstapels entkoppelt, sodass die Hilfsbewegungen mit niedriger Wiederholungsgenauigkeit von kleiner 1 mm, bevorzugt kleiner 500 Mikrometer, besonders bevorzugt kleiner 150 Mikrometer ausgeführt werden.

Die Steuerung und/oder Regelung von der Bewegungseinrichtung der Vorrichtung zum Ausrichten zur (lateralen) Ausrichtung (Feinjustierung) wird insbesondere auf Basis von den erfassten X-Y-Z-Positionen und/oder Ausrichtungslagen durchgeführt. Dazu werden die zusätzlichen Ausrichtungsmarken des Substrats mit dem in einem Sichtfeld auf der Oberfläche des Substrathalters dazu ein-eindeutig zugeordneten Justierungsmarken des Justierungsmarkierungsfeldes korreliert. Die Höheninformation und die Winkellage sowie deren Korrektur wird aus der Justierungsmarkierung des Justierungsmarkierungsfeldes errechnet. Dies ergeben eine X-Y-Z-Position und eine räumliche Orientierung, welche insbesondere kontinuierlich bei der Zustellbewegung der Ausrichtung und bei der Einstellung des Abstandes zum Bonden beobachtbar ist und insbesondere zur Fehlerkorrektur der Zustellbewegung in Echtzeit verwendbar ist.

Die Genauigkeit der Bewegungseinrichtungen für die Ausrichtung ist kleiner 500 nm, bevorzugt kleiner 100 nm, besonders bevorzugt kleiner 50 nm, ganz besonders bevorzugt kleiner 10 nm, bevorzugter 5 nm, am bevorzugtesten kleiner 1 nm.

In besonders bevorzugten Ausführungsformen der Vorrichtung beträgt der Fehler der Ausrichtungsgenauigkeit der Vorrichtung weniger als 20% des zulässigen höchsten Ausrichtungsfehlers, bevorzugt weniger als 10%, am bevorzugtesten weniger als 1%.

Mit anderen Worten beträgt der zulässige Ausrichtungsfehler der Substrate beispielsweise 10 nm, dann beträgt der Positionierfehler höchstens 20% des Wertes, also 2 nm.

In einer besonders bevorzugten Ausführungsform des Substrathalters kann der Substrathalter als nicht-monolithischer Körper aus mehreren Bauteilen bestehen. Die Substratauflagefläche beinhaltet zumindest ein Justierungsmarkierungsfeld mit den Justierungsmarkierungen und die insbesondere verteilte, punktuelle Auflagen für die Auflage eines Substrats. Die Substratauflagefläche bildet einen Teil eines Inserts, welches ein reproduzierbar elastisch verformbarer Körper ist. Das Insert wird insbesondere statisch bestimmt in einem Grundkörper aufgenommen. Die Substratauflagefläche ist durch entsprechend gestalteten Kanälen und Düsen und Zuleitungen fluidisch an insbesondere Vakuum angeschlossen, welcher Unterdruck auch in Überdruck umgestellt werden kann.

Das Insert wird im Grundkörper insbesondere geklemmt. Zumindest die der Substrathalteroberfläche abgewandten Rückseite des Inserts wird insbesondere gasdicht im Grundkörper des Substrathalters isoliert aufgenommen, sodass mittels Vakuum oder Überdruck das Insert reproduzierbar verformbar ist.

Die fluidische Verbindung des Raumes des Grundkörpers des Substrathalters mit der Rückseite des Inserts kann unabhängig mit geregeltem Überdruck bzw. Unterdruck beaufschlagt und dadurch die Verformung des Inserts bewirken.

Eine beispielhafte Ausführungsform eines Verfahrens zur Justierung eines Erfassungsmittels erfolgt insbesondere mit folgendem Ablauf mit insbesondere folgenden Schritten.

Erster Verfahrensschritt: Zumindest ein Erfassungsmittel wird in die erwartete Position einer Ausrichtungsmarkierung des auszurichtenden Substrates bewegt. Diese Positionierung ist mit einer Positionierunsicherheit behaftet.

Zweiter Verfahrensschritt: Der Substrathalter wird befestigt, sodass keine Bewegungen des Substrathalters erfolgen.

Dritter Verfahrensschritt: Das Erfassungsmittel fokussiert auf eine Justierungsmarkierung eines Justierungsmarkierungsfeldes und erfasst die Justierungsmarkierung.

Vierter Verfahrensschritt: Aus dem Wissensspeicher und/oder aus einer Datenbank wird die gespeicherte Position der Justierungsmarkierung abgerufen und mit dem erfassten Messwert des Erfassungsmittels korreliert. So wird die räumliche Position, insbesondere absolute Position der erfassten Justierungsmarkierung gespeichert.

Fünfter Verfahrensschritt: Das Erfassungsmittel fokussiert auf eine weitere Justierungsmarkierung einer zweiten Ebene der Justierungsmarkierung. Dabei findet in der Vorrichtung nur eine Fokussierbewegung bevorzugt in der z-Richtung statt.

Sechster Verfahrensschritt: die weitere Justierungsmarkierung wird erfasst und die Position- sowie die Lage der weiteren Justierungsmarkierung berechnet.

Siebter Verfahrensschritt: insbesondere aus dem Speicher bekannten Höhe und aus der berechneten z-Fokussierungshöhe sowie aus einer insbesondere x-y-lateralen Verschiebung der weiteren Justierungsmarkierung wird die relative Position und/oder die Winkellage des Erfassungsmittels im Bezug zur lokalen Normalrichtung des Substrathalters berechnet. Dieser Wert kann als Korrekturwert für die Folgeverfahren verwendet werden.

In einer vorteilhaften Ausführungsform können die gesuchten Justierungsmarkierungen in einem Radius kleiner 3 Millimeter, bevorzugt kleiner 2 Millimeter, besonders bevorzugt kleiner 1 Millimeter, ganz besonders bevorzugt kleiner 500 Mikrometer, noch bevorzugter kleiner 250 Mikrometer in der Umgebung der optischen Achse des jeweiligen Objektivs der Erfassungseinheiten erfasst werden.

Durch Messsystem mit zumindest einer Erfassungseinheit zum Erfassen von Justierungsmarken eines Justierungsmarkierungsfeldes (insbesondere ein Messmikroskop mit Objektiv) wird eine erste Justierungsmarke einer ersten Ebene und somit eine X-Y-Z-Position und/oder Ausrichtungslage des Substrathalters erfasst. Dabei wird der Substrathalter festgehalten und die Position beziehungsweise die Positionen der zusätzlichen Ausrichtungsmarkierung des unteren Substrats zu der erfassten Position korreliert. Zur Erfassung der Position des Substrathalters wird das ortsfest zu dem Substrathalter angeordnete Justierungsmarkierungsfeld verwendet.

Bevorzugt wird eine Stufe des Justierungsmarkierungsfeldes fokussiert erfasst, welche nah zur freien Oberfläche des Justierungsmarkierungsfeldes liegt und Justierungsmarkierungen in der gesamten Tiefe des Justierungsmarkierungsfeldes betrachtet werden können.

In dieser fokussierten Lage wird die Fokusposition und somit der Fokusbereich (insbesondere des Objektivs) der Erfassungseinheit zur Erfassung des Justierungsmarkierungsfeldes befestigt. Weiterhin wird die Erfassungseinheit insbesondere örtlich fixiert beziehungsweise ortsfest gehalten.

Bei der Refokussierung wird in der Anfangsposition mindestens eine Justierungsmarke einer ersten Ebene erfasst und in der Zielposition mindestens eine Justierungsmarke einer zweiten Ebene des Justierungsmarkierungsfeldes erfasst.

Die Position des Substrathalters wird mittels der gemessenen Positionsfehler und/oder Winkelfehler zumindest in der lateralen Ebene korrigiert. Dabei wird das Erfassungsmittel so bewegt, dass die entsprechende mindestens eine zweite Justierungsmarke der zweiten Ebene scharf gestellt ist, beziehungsweise im Fokusbereich der Erfassungseinheit liegt. Auf diese Weise kann durch eine Sichtkontrolle sichergestellt werden, dass der Abstand zwischen der ersten Ebene und der zweiten Ebene ausreichend genau angefahren wurde.

Somit kann auf die Repositionierung des Substrathalters verzichtet werden und Ausrichtungsfehler vermieden werden, da Korrekturwerte verwendbar sind. Durch das Justierungsmarkierungsfeld wird eine Höheninformation bereitgestellt. Bei der Ausrichtung der Substrate zueinander können Korrekturen an deren relativen Position zueinander durchgeführt werden, falls der Ausrichtungsfehler einen festgelegten Grenzwert überschreitet. Zu diesen Korrekturen liefert das Verfahren zur Justierung einen Korrekturwert.

Die Ausrichtungsfehler, bei welchen Korrekturen angewendet werden können sind für Verschiebungen kleiner 500 Mikrometer, bevorzugt kleiner 100 Mikrometer, besonders bevorzugt kleiner 100 Nanometer, ganz besonders bevorzugt kleiner 10 Nanometer, noch bevorzugter kleiner 5 Nanometer, am bevorzugtesten kleiner als 1 Nanometer.

Die Ausrichtungsfehler, bei welchen Korrekturen für Verdrehungen angewendet werden können, sind kleiner 50 Mikroradiant, bevorzugt kleiner 10 Mikroradiant, besonders bevorzugt kleiner 5 Mikroradiant, ganz besonders bevorzugt kleiner 1 Mikroradiant, noch bevorzugter kleiner 0,1 Mikroradiant, am bevorzugtesten kleiner als 0,05 Mikroradiant.

Mit anderen Worten erlaubt das Verfahren, die unterschiedlichen Ebenen eines Justierungsmarkierungsfeldes nach einer Sequenz definierten Relativbewegungen zu vermessen, um daraus die relative Position und/oder Ausrichtungslage der beiden gemessenen Objekte zueinander abzuleiten, um damit Korrekturwerte zu erzeugen, welche wiederum die Ausrichtungsgenauigkeit des Substratstapels erhöht.

Stehen die beobachteten Ebenen des Justierungsmarkierungsfeldes nicht normal zur z-Achse zumindest eines der Erfassungsmittel, verursacht jede Relativbewegung eine Verschiebung in der x-y-Ebene und/oder einen Winkelfehler (Gierfehler und/oder Nickfehler und/oder Rollfehler), welcher erfassbar und entsprechend korrigierbar ist.

Insbesondere als eigenständige Vorrichtung kann ein Substrathalter mit integriertem Justierungsmarkierungsfeld verstanden werden. Bevorzugt beinhaltet ein Substrathalter die Justierungsmarken zumindest eines Justierungsmarkierungsfeldes nahe der Substratauflagefläche des Substrathalters so abgesetzt, dass bei der Verwendung des Substrathalters kein Kontakt zwischen dem Substrat und den Justierungsmarken kommt. Mit anderen Worten berühren sich die Justierungsmarken des Justierungsmarkierungsfeldes und das Substrat beim aufliegenden Substrat auf der Substrathalteroberfläche in keinem Zeitpunkt. Besonders vorteilhaft ist die Verwendung eines Noppenprobenhalters mit integriertem Justierungsmarkierungsfeldern.

In einer vorteilhaften Ausführungsform des Substrathalters können die einzelnen Justierungsmarken des Justierungsmarkierungsfeldes am Substrathalter so platziert sein, dass sie in der Umgebung der Ausrichtungsmarken am Substrat sind. Zweck der Platzierung ist es, die Vorrichtung ohne Substrat mit dem Erfassungsmittel zu kalibrieren und/oder zu justieren, insbesondere einen Winkelfehler der einzelnen Erfassungsmittel zu vermessen, um bei der Ausrichtung kalibrierte Werte der Vorrichtung verwenden zu können. Vorzugsweise werden nach der Kalibrierung die Erfassungsmittel in der Position gesperrt, festgehalten. Bei der Verwendung des Substrathalters zur Ausrichtung von Substraten können so ohne Nachstellbewegungen der Erfassungsmittel die Justierungsmarken der Substrate erfasst werden. Mit anderen Worten fallen die insbesondere z-Achsen der Justierungsmarkierungen des Justierungsmarkenfeldes mit den z-Achsen der Ausrichtungsmarken der Substrate lokal im Sichtfeld der einzelnen Erfassungsmittel zusammen. Damit können die kalibrierten Erfassungsmittel und Substrathalter ohne Repositionierung zur Ausrichtung der Substrate verwendet werden.

Die Begriffe, dass Achsen zusammenfallen oder Deckungsgleichheit oder Parallelität oder Normalität werden in dieser Offenbarung als Begriffe toleranzbehafteter Größen verwendet, sodass insbesondere die Toleranzen nicht tolerierten Längen- bzw. Winkelmaße gemäß ISO 2768 gelten, es sei denn die Toleranzen sind explizit angegeben.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen schematisch in:
- Figur 1: eine Querschnittsdarstellung einer Ausführungsform einer Vorrichtung zur Justierung eines Erfassungsmittels,
- Figur 2a: eine Draufsichtdarstellung einer beispielhaften Anordnung der Justierungsmarken beziehungsweise der Justiermarkierungsfelder zwischen Erhöhungen des Substrathalters
- Figur 2b: eine Schnittdarstellung einer Ausführungsform eines Justierungsmarkierungsfeldes,
- Figur 3: eine Draufsichtdarstellung einer Ausführungsform eines Justierungsmarkierungsfeldes mit Justierungsmarken,
- Figur 4: eine Schnittdarstellung einer Ausführungsform eines Justierungsmarkierungsfeldes mit einer Erfassungseinheit,
- Figur 5 a: eine Erfassungseinheit in einer ersten Position und

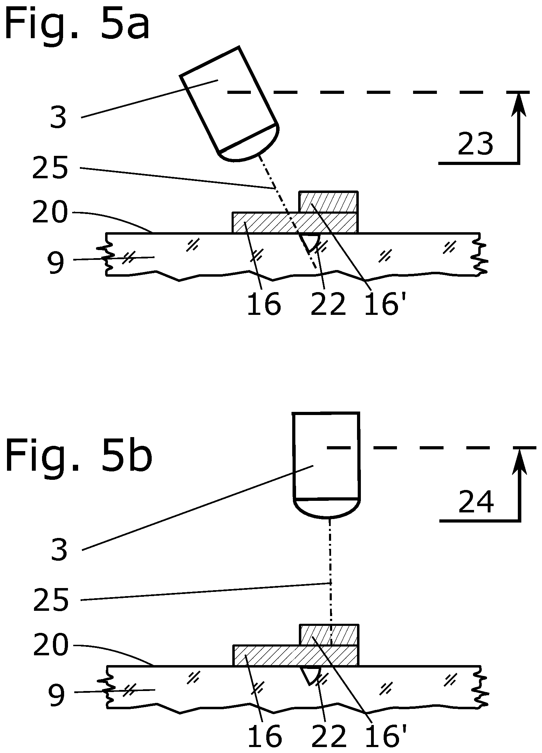

- Figur 5 b: die Erfassungseinheit in einer zweiten Position.

In den Figuren sind Vorteile und Merkmale der Erfindung angegeben. Dabei sind die dargestellten Ausführungsformen mit Bezugszeichen versehen. Die einzelnen Bauteile beziehungsweise Merkmale mit gleicher oder gleichwirkender Funktion sind mit den gleichen Bezugszeichen gekennzeichnet.

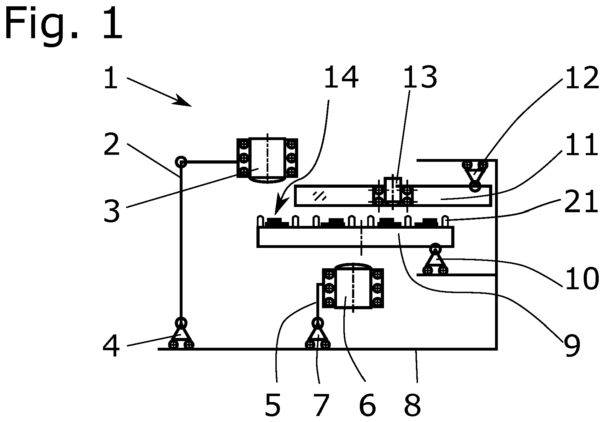

In Fig. 1 ist eine schematische Funktionaldarstellung der Vorrichtung zur Justierung eines Erfassungsmittels abgebildet. Dabei ist die Vorrichtung Teil einer Ausrichtungsanlage 1 zum Ausrichten beziehungsweise zum Bearbeiten von Substraten. Die Ausrichtungsanlage 1 kann Substrate (nicht eingezeichnet) zueinander ausrichten und miteinander zumindest teilweise und/oder vorläufig (sogenannter Pre-Bond) verbinden.

Die Ausrichtungsanlage 1 beinhaltet einen ersten Substrathalter 9, auf welchem ein erstes Substrat auf einer Substrathalteroberfläche geladen werden kann und fixierbar ist. Weiterhin beinhaltet die Ausrichtungsanlage 1 einen zweiten Substrathalter 11, auf welchem ein zweites Substrat geladen werden kann und fixierbar ist.

Der erste, insbesondere untere, Substrathalter 9 ist an einer ersten Bewegungseinrichtung 10 zur Halterung und Umsetzung von Zuführ- sowie Justierbewegungen (Ausrichtung) des ersten Substrathalters 9 angeordnet. Der zweite, insbesondere obere, Substrathalter 11 ist an einer zweiten Bewegungseinrichtung 12 zur Halterung und Umsetzung von Zuführ- sowie Justierbewegungen (Ausrichtung) des zweiten Substrathalters 11 angeordnet. Die Bewegungseinrichtungen 10, 12 sind an einem gemeinsamen, massiven Tisch oder Gestell 8 fixiert, um Schwingungen der funktionalen Bauteile zu reduzieren/minimieren. Das Gestell kann insbesondere eine aktive Schwingungsdämpfung beinhalten.

Zur Erfassung von Ausrichtungsmarkierungen auf den Substraten (nicht eingezeichnet) können die optischen Systeme 2, 5 der Ausrichtungsanlage 1 ebenfalls verwendet werden. Durch die Erfassungsmittel 3, 6 (insbesondere Optiken) können somit auch Achtungsmarkierungen auf dem Substrat oder dem Substrathalter erfasst werden. Dabei ist das optische System 2 primär zur Erfassung von Justiermarken eines Justiermarkierungsfeldes ausgebildet.

Das optische System 2, insbesondere das Erfassungsmittel 3 ist auf eine Fokusebene beziehungsweise Fokusposition fokussierbar. Dabei ist innerhalb eines Fokusbereiches 19 zumindest eine Justiermarke erfassbar. Der Abstand horizontale Abstand (z-Richtung) zwischen den Justiermarken unterschiedlicher Ebenen eines Justiermarkierungsfeldes sind dabei bekannt und können zusätzlich anhand eines Informationsgehaltes einer Justiermarkierung ausgelesen werden (z.B. QR-Code). Bewegungen des optischen Systems 2, insbesondere in X-, Y- und Z-Richtung, werden mittels einer Positioniervorrichtung 4 zur Positionierung des optischen Systems 2 durchgeführt. Die Positioniervorrichtung 4 kann insbesondere an dem massiven Gestell 8 fixiert werden.

Soweit es sich um ein optisches Messsystem 2 handelt, kann die Positioniereinrichtung 4 eine Fokussierung in Bezug auf eine Justierungsmarke einer ersten Ebene 18 eines Justierungsmarkierungsfeldes 14 durch Bewegung der Erfassungseinheit 3 in Z-Richtung vornehmen. Eine Positionierung in X-Y-Richtung ist ebenfalls denkbar, wobei während der Justierung insbesondere eine Fixierung. vorzugsweise an dem Tisch/Gestell, erfolgt.

Weiterhin kann in der dargestellten Ausführungsform der Ausrichtungsanlage 1 mit der Erfassungseinheit 3 eine Justierungsmarke 15 eines Justierungsmarkierungsfeldes 14 in x-y-z-Position erfasst werden. Nach einer Refokussierung beziehungsweise Umfokussierung auf eine weitere Ebene (Abstand zwischen den Ebenen des Justierungsmarkierungsfeldes 14 bekannt) wird aus der bekannten Höhe der Ebenen beziehungsweise aus dem bekannten Abstand zwischen den Ebenen eines Justiermarkierungsfeldes und aus der parasitären, lateralen Bewegung des Erfassungsmittels 3 bei festgehaltenem Substrathalter 9 die tatsächliche räumliche Winkellage erfasst. Dabei wird somit der Keilfehler der Optik 3 und dem Substrathalter 9 beziehungsweise der Aufnahmefläche des Substrathalters 9 bestimmt. Die Optik 3 kann somit vorteilhaft anhand des Justiermarkierungsfelds in Bezug auf den Substrathalter 9 justiert werden beziehungsweise kalibriert werden. Zudem kann die Position des Erfassungsmittels 3 berechnet werden. Die Position kann als Korrekturfaktor für die Verminderung des Ausrichtungsfehlers des Substratstapels verwendet. Ein nicht dargestelltes Substrat wird insbesondere auf die, aus mehreren Einzelflächen bestehender Substrathalteroberfläche 20 aufgenommen. Bevorzugt besteht die Substrataufnahmefläche 20 aus einer Vielzahl von Noppen 21.

In der dargestellten Ausführungsform der Ausrichtungsanlage 1 kann zudem mit dem Messsystem 5 beziehungsweise der Erfassungseinheit 6 insbesondere die X-Y-Position und/oder Lage (insbesondere auch die Rotationslage) und/oder die Höhenposition des unteren Substrathalters 9 mit besonders hoher Genauigkeit erfasst.

Zur Einleitung eines Fusionsbondes kann zumindest das obere Substrat mit einer Substratvorspannungsvorrichtung 13 vorgespannt werden. Die Vorspannung kann mittels mechanischer Vorspannung mit einem Vorspannelement, ein sogenannter Bondpin, erfolgen. In einer weiteren Ausführungsform der Substratvorspannungsvorrichtung kann die Vorspannung des Substrats mit einem Fluid, insbesondere mit einem Gas aus einer Düse, insbesondere aus einer beweglichen Düse erfolgen.

Mit nicht dargestellten, jedoch bevorzugten Ausführungsformen der Vorrichtung können folgende, beispielhaft aufgeführte Verfahrensschritte durchgeführt werden:
Auf der Substrathalteroberfläche des ersten Substrathalters 9 wird das erste Substrat befestigt. Als Befestigung wird insbesondere eine mechanische und/oder elektrostatische Klemmung, Anpresskraft, welche wegen einer Druckdifferenz zwischen Umgebung in Normalatmosphäre und Unterdruck am ersten Substrathalter 9 erzeugt wird, auch als Vakuumfixierung genannt, verwendet. Die Befestigung erfolgt insbesondere so, dass das erste Substrat während des gesamten Verfahrens relativ zum ersten Substrathalter 9 keine ungenaue oder unerwünschte Bewegung erfährt. Es kann insbesondere eine thermische Wärmedehnung unterbunden oder reduziert werden, soweit der erste Substrathalter 9 und das erste Substrat jeweils einen korrespondierenden, vorzugsweise linear korrespondierend verlaufenden, Wärmedehnungskoeffizienten besitzen, wobei der Unterschied der Wärmedehnungskoeffizienten und/oder des linearen Verlaufs der Wärmedehnungskoeffizienten vorzugsweise weniger als 5%, bevorzugt weniger 3%, besonders bevorzugt weniger 1%, beträgt.

Bevorzugt wird die Anlage in einer temperaturstabilisierten Umgebung, insbesondere in einem Reinraum, betrieben in welcher eine Temperaturschwankung kleiner als 0,5 Kelvin, bevorzugt kleiner als 0,1 Kelvin, besonders bevorzugt kleiner als 0,05 Kelvin, am bevorzugtesten kleiner als 0,01 Kelvin während eines Justierungs- bzw. Ausrichtungszyklus beträgt.

Das fixierte erste Substrat und insbesondere ein Insert des Substrathalter 9 können als quasi-monolithischer Körper für die Ausführung der Bewegungen des ersten Substrats verstanden werden, welche keine Relativbewegungen zueinander erlauben.

Diese Substratbefestigung kann formschlüssig und/oder bevorzugt kraftschlüssig erfolgen. Die quasi-monolithische Verbindung führt dazu, dass die Einflüsse, welche zwischen dem Substrathalter und Substrat eine Verschiebung und/oder Verdrehung und/oder Deformation bewirken können, mindestens reduziert, bevorzugt mindestens eine Größenordnung reduziert, besonders bevorzugt eliminiert werden. Somit kann zusammen mit der Justierung des Erfassungsmittels 3 zum Substrathalter der Ausrichtungsfehler weiter reduziert werden.

Mit Formschluss oder Kraftschluss kann das Substrat mit dem Substrathalter 9 so verbunden werden, dass insbesondere die Differenz einer thermischen Dehnung unterdrückt werden kann. Weiterhin kann mit dem Substrathalter die eigenständige Deformation des Substrates reduziert, eliminiert und/oder korrigiert werden. Zusätzlich zu diesen Maßnahmen wird zumindest ein Erfassungsmittel zum Substrathalter, insbesondere zur den Justierungsmarkierungen des Justierungsmarkierungsfeldes der Substrathalteroberfläche in definierter Position und Winkellage befinden, sodass einerseits die langsamen thermischen Relativbewegungen erfassbar und korrigierbar werden, andererseits können durch die Vorabjustierung der Position und Winkellage des Erfassungsmittels die Positionierfehler des Substrathalters zu Erfassungsmittel zumindest reduziert werden.

In einer Ausführungsform können sowohl der untere Substrathalter 9 als auch der obere Substrathalter 11 zusätzliche, passiv und/oder aktiv betriebene Verformungselemente und/oder Zwischenplatten, auch Inserts genannt, beinhalten, um die mechanischen und/oder thermischen Eigenschaften der Substrate für die Reduzierung des Restfehlers der Ausrichtung nach dem Fügen zu minimieren.

Der erste Substrathalter 9 kann sich während der Erfassung einer ersten Justierungsmarke 15 eines Justierungsmarkierungsfeldes 14 in einem optischen Pfad der Erfassungseinheit 3 befinden.

Bevorzugt wird eine Erfassungseinheit oder damit gleichbedeutend ein Erfassungsmittel fluchtend beziehungsweise senkrecht zu einer definierten Justierungsmarke eines Justierungsmarkierungsfeldes 14 angeordnet, sodass eine Erfassung einer Ausrichtungsmarkierung eines zu bondenden Substrats in der gleichen x-y-Position keine Repositionierung des Substrathalters und/oder des Erfassungsmittels benötigt. So wird mittels Reduzierung der benötigten Bewegungen und Erfassung und Justierung von Positionen die Genauigkeit der Ausrichtung des Substratstapels erhöht.

Der untere Substrathalter weist die Justierungsmarken 15 des Justierungsmarkierungsfeldes 14 auf. Anhand der Justiermarken 15 kann zudem X-Y-Z-Position und die Ausrichtungslage der jeweiligen Justiermarke 15 innerhalb des Justiermarkierungsfeldes bestimmt werden. Durch das Erfassen einer weiteren Justiermarke 15 in einer anderen Ebene desselben Justiermarkierungsfeldes 14 ist dabei der Keilfehler beziehungsweise die Winkellage des Substrathalters 9 relativ zum Erfassungsmittel 3 erfassbar.

Dazu ist denkbar, dass statt einer Relativbewegung (oder Umfokussierung) des Erfassungsmittels 3, der Substrathalter 9 eine Relativbewegung in Z-Richtung vollführt und das Erfassungsmittel festgehalten wird. Aus diesem Justierungsverfahren kann ein ähnlicher Korrekturwert einer Relativposition errechnet werden, welche insbesondere eine parasitäre Bewegung des Substrathalters zum festgehaltenen Erfassungsmittel bestimmt.

Dabei kann auch die Erfassungseinheit 6 zur Erfassung von Justiermarken 15 auf unterschiedlichen Ebenen eines des Justierungsmarkierungsfeldes 14 verwendet werden, wenn der Substrathalter für die Erfassungseinheit 6 transparent ist.

Die Messwerte (X-Y-Position und/oder Ausrichtungslage des ersten Substrats sowie X-Y-Z-Position und/oder Ausrichtungslage des ersten Substrathalters 9 oder des ersten Substrats) können nach der Anwendung der Justierung/Korrektur miteinander korreliert werden, so dass die X-Y-Z-Position des Substrathalters 9 und/oder des Erfassungsmittels reproduzierbar wiederherstellbar ist. Damit kann das auf dem Substrathalter 9 befestigte Substrat zur Ausrichtung sowie zur Einstellung des Bondabstands geregelt bewegt werden, ohne dass die Justierungsmarkierungen 15 des Substrathalters 9 oder die Ausrichtungsmarkierungen eines Substrats direkt beobachtbar sind.

Durch eine Zuordnung der Position des Substrats zur räumlichen Position und/oder Lage des Substrathalters 9 bzw. des Erfassungsmittels 3 wird eine Ausrichtung ohne direkte Beobachtung der X-Y-Z-Positionen und/oder Ausrichtungslagen und/oder relativen Winkellagen des jeweiligen Substrats während der Ausrichtung und/oder Kontaktierung realisierbar. Die ermittelten Korrekturwerte erhöhen die Positioniergenauigkeit durch die Reduzierung der Positionierunsicherheiten vor beziehungsweise während der Ausrichtung und Kontaktierung eines ersten Substrats mit dem zweiten Substrat. Weiterhin kann der Abstand zwischen den Substraten während der Ausrichtung definiert eingestellt und/oder minimiert werden, dazu können zusätzliche Justierungsmarkierungsfelder insbesondere auf der Substrataufnahmefläche abgewandten Rückseite des Substrathalters verwendet werden.

Insbesondere wird eine Wiederholungsgenauigkeit der Positionierung (gemessen als relativer Ausrichtungsfehler zwischen den zwei Substraten), auch als Umkehrspiel bekannt, von unter 500 nm, bevorzugt unter 100 nm, besonders bevorzugt unter 30 nm, ganz besonders bevorzugt unter 10 nm, noch bevorzugter unter 5 nm, am bevorzugtesten unter 1 nm erreicht.

Das Umkehrspiel resultiert aus den Bewegungen der Bewegungseinrichtungen, lediglich der Erfassungsort variiert, sodass die Messgröße als relativer Ausrichtungsfehler existiert. Das Verfahren reduziert durch die lokale Messung der Fehlstellung des Erfassungsmittels 3 die lokale Positionierungenauigkeit, welche folglich den lokalen Ausrichtungsfehler weiter reduziert.

Es ist zur weiteren Erhöhung der Ausrichtungsgenauigkeit kann eine erste Erfassungseinheit 3 mit zumindest einer weiteren zusätzlichen Erfassungseinheit 6 zeitsynchronisiert betrieben werden. Dabei beträgt der Zeitunterschied der Erfassungen der Messwerte unter 3 Sekunden, bevorzugt unter 1 Sekunde, besonders bevorzugt unter 500 Millisekunden, ganz besonders bevorzugt unter 100 Millisekunden, noch bevorzugter Fall unter 10 Millisekunden, am bevorzugtesten unter 1 Millisekunden, im idealen Fall gleichzeitig. Dies ist besonders vorteilhaft, weil die Wirkung von Störeinflüssen wie mechanische Schwingungen eliminiert werden können. Mechanische Schwingungen breiten sich unter anderem mit Körperschall mit einigen Tausend m/s in den Werkstoffen aus. Falls eine Regelung und die Erfassungsmittel schneller arbeiten als die Ausbreitungsgeschwindigkeit des Körperschalls, wird eine Störung reduziert oder eliminiert.

Werden eine Erfassungseinheit 3 und die Erfassungseinheit 6 zur Erfassung des Justierungsmarkierungsfeldes 14 und eines weiteren Justierungsmarkierungsfeldes auf der Rückseite des Substrathalters zueinander synchronisiert (insbesondere durch zeitgleiche Auslösung der Erfassung sowie Ausgleich der Erfassungszeit und/oder gleiche Integrationszeit für Kamerasysteme), können einige Störeinflüsse reduziert, im optimalen Fall eliminiert werden, da die Erfassung zu einem Zeitpunkt erfolgen soll, in dem die Störeinflüsse möglichst minimale Auswirkung auf die Erfassungsgenauigkeit haben.

In einer bevorzugten Ausführungsform des Verfahrens und der Vorrichtung zur Justierung eines Erfassungsmittels sowie bei der Vorrichtung zur Justierung wird bei bekannten, insbesondere periodischen Störeinflüssen, insbesondere im Scheitelpunkt der Schwingung, die Erfassung synchronisiert erfolgen. Mit Vorzug können dazu im Vorfeld Schwingungssensoren (Beschleunigungssensoren, Interferometer, Vibrometer) an für die Genauigkeit relevanten Stellen der Vorrichtung angebracht werden. Die Störeinflüsse werden von diesen Schwingungssensoren aufgenommen und zur Eliminierung durch Berechnung berücksichtigt beziehungsweise bereinigt. In einer weiteren Ausführungsform können die Schwingungssensoren an den charakteristischen Stellen der Anlage fest verbaut werden.

Für die Justierung von dem Erfassungsmittel oder ggf. mehreren Erfassungsmitteln ist es vorteilhaft, wenn das Justierungsmarkierungsfeld 14 vollständig vermessen wird und die Sollwerte in einem Speicher für den Vergleich bzw. Differenzbildung bereitgestellt werden. Der Sollwert beinhaltet insbesondere Bilddaten der Justierungsmarken des Justierungsmarkierungsfeldes 14 des ersten Substrathalters 9 und/oder Regelungsparameter wie Bahnkurven zum optimalen Anfahren der räumlichen Position und/oder insbesondere maschinenlesbare Werte für die Antriebe, insbesondere für die Fokussierung des Erfassungsmittels 3. In anderen Worten ist die Lage der einzelnen Justiermarken eines Justiermarkierungsfeldes und weiteren Justiermarken eines weiteren Justiermarkierungsfeldes bekannt und abgespeichert.

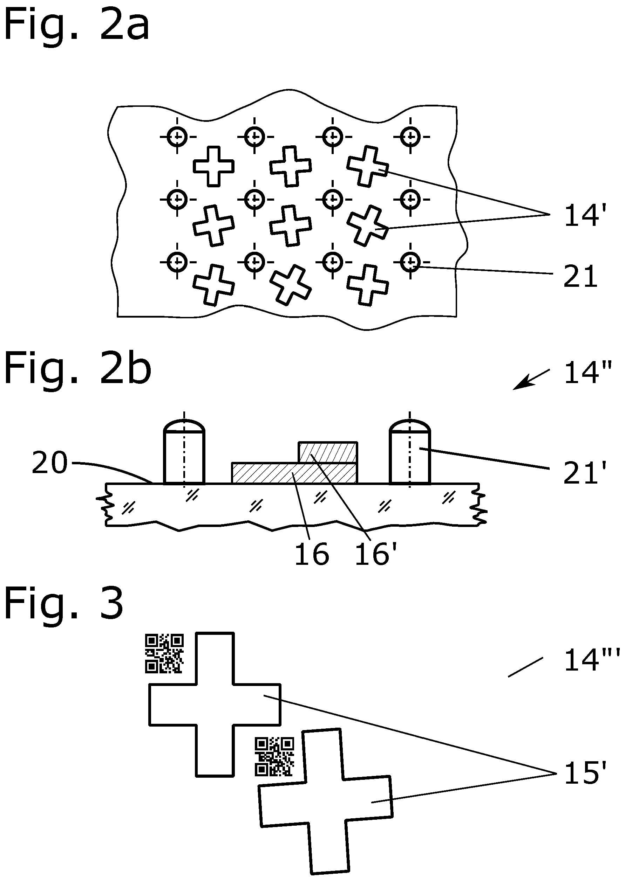

Figur 2a zeigt mehrere Justierungsmarkierungsfelder in schematischer, stark vergrößerter Draufsicht mit jeweils einer exemplarische ausgewählten sowie sichtbaren Justierungsmarke 15 beziehungsweise Justierungsmarkierung 15.

Die einzelnen Justierungsmarken 15 stellen symbolisch und schematisch eine absolute, eindeutige Kodierung der Position und der Lage jeder einzelnen Justierungsmarke beziehungsweise Justierungsmarkierung 15 dar. Die einzelnen Justierungsmarken 15 bzw. Justierungsmarkierungen 15 können in unterschiedlichen Ebenen des Justierungsmarkierungsfelder vorliegen. Da die x-y-z-Position einer jeder Ausrichtungsmarkierung 15 bekannt sind, reicht für eine Positionserfassung des nicht dargestellten Substrathalters aus, dass eine kodierte Justierungsmarke 15 bzw. Justierungsmarkierung 15 erfasst wird. Demnach kann eine Refokussierung (oder eine Relativbewegung in z-Richtung bei gleicher Fokussierung) auf eine weitere Justierungsmarke 15 bzw. Justierungsmarkierung erfolgen desselben Justiermarkierungsfeldes erfolgen, sodass die Winkellage/der Keilfehler des Erfassungsmittels relativ zum Substrathalter bestimmbar ist. Die Justierung des Erfassungsmittels kann somit vorteilhaft anhand eines Justiermarkierungsfeldes erfolgen.

Figur 2b zeigt ein Justierungsmarkierungsfeld 14" mit unterschiedlichen Schichten 16, 16' beziehungsweise Stufen. Die Justiermarken einer Stufe sind somit in einer Ebene angeordnet und weisen einen bestimmten sowie bekannten Abstand zu den Justiermarken einer anderen Stufe beziehungsweise Ebene des Justierungsmarkierungsfeldes 14" auf. In der dargestellten Ausführungsform ist das Justiermarkierungsfeld 14" zwischen den Erhöhungen beziehungsweise Noppen 21' angeordnet.

Das Justierungsmarkierungsfeld 14" ist relativ zu dem Substrathalter beziehungsweise der Substrathalteroberfläche 20 ortsfest angeordnet. Dabei sind die Auflageflächen Erhöhungen 21' (zur Aufnahme des Substrates) höher als der höchste Punkt des Justiermarkierungsfeldes 14" beziehungsweise weisen zu der Substrathalteroberfläche einen größeren Abstand auf. Die Justiermarkierungsfelder sind somit zu der Substrathalteraufnahmefläche (Auflageflächen der Erhöhungen) abgesetzt. Dadurch kommen die Justierungsmarken bzw. Justierungsmarkierungen (der obersten Ebene des jeweiligen Justiermarkierungsfeldes) vorteilhaft nicht mit dem Substrat in Berührung.

Die reduzierte Auflagefläche der Noppen 21' bewirkt, dass ein Substrat nicht vollflächig aufliegt, sodass die eventuell vorhandenen Partikel auf der Rückseite eines Substrats keine Verzerrungen verursachen. Dadurch wird eine Querkontamination des Substrats beziehungsweise des Substrathalters vorteilhaft minimiert.

Das Justiermarkierungsfeld ist ortsfest zu dem Substrathalter angeordnet Dabei können insbesondere die Justiermarken auf unterschiedlichen Ebenen beziehungsweise auf mehrere Stufen und/oder Schichten 16, 16'nacheinander im Blickfeld beziehungsweise Fokusbereich der Erfassungseinheit 3 liegen und somit erfasst werden. Durch die bekannten Stufenhöhen beziehungsweise den bekannten Abständen zwischen den Ebenen und bekannten Positionen der Justierungsmarkierungen können diese zur Ermittlung des Winkelfehlers des refokussierten Erfassungsmittels verwendet werden.

Es ist möglich, dass für die Ermittlung von Korrekturwerten aus der Position und Winkellage des Erfassungsmittels ein modifiziertes Verfahren verwendet wird, welche die Schichten 16 und 16' des Justierungsmarkierungsfeldes 14" insbesondere mit folgenden Schritten, mit folgendem Ablauf vermisst:
In einem ersten Verfahrensschritt wird der Substrathalter um die Substratdicke in eine z-Richtung angehoben. In einem zweiten Verfahrensschritt wird zumindest ein Erfassungsmittel 3 in die erwartete x-y-Position der Ausrichtungsmarke des Substrats bewegt und in x-y festgehalten. In einem dritten Verfahrensschritt wird zumindest ein Erfassungsmittel auf eine Justierungsmarkierung eines Justierungsmarkierungsfeldes 14 des Substrathalters fokussiert und die Justierungsmarkierung in x-y-Position sowie eine Rotation um die Z-Achse erfasst. In einem vierten Verfahrensschritt wird der Substrathalter in eine Z-Richtung weg von dem festgehaltenen Erfassungsmittel bewegt, sodass eine weitere Justiermarke einer anderen Ebene beziehungsweise Schicht 16 oder 16' erfassbar wird. In einem fünften Verfahrensschritt wird eine Justierungsmarkierung der entsprechenden Schicht 16 oder 16' und die relative Verschiebung aus der Bewegung des Substrathalters und den parasitären Bewegungen ermittelt und mit den Idealwerten verglichen die Korrekturwerte berechnet. Dabei wird ein Korrekturwert für die Winkelstellung der Relativlage zwischen Substrathalter und Erfassungsmittel berechnet. Im Anschluss wird das Erfassungsmittel justiert beziehungsweise der Keilfehler ausgeglichen.

Der Abstand zwischen den Ebenen beträgt zwischen 1 Mikrometer und 300 Mikrometer, bevorzugt zwischen 5 Mikrometer und 200 Mikrometer, bevorzugter zwischen 10 Mikrometer und 100 Mikrometer, besonders bevorzugt zwischen 25 Mikrometer und 75 Mikrometer, am bevorzugtesten zwischen 48 Mikrometer und 52 Mikrometer. Beispielsweise beträgt der Abstand zwischen den Ebenen 50,00 Mikrometer.

Zudem ist es vorteilhaft, wenn die jeweiligen zusätzlichen Justierungsmarken 15, 15' eine erfassbare Lageinformation aufweisen. Mit einer Vielzahl von Justierungsmarkierungsfeldern zwischen den Erhöhungen/Noppen 21, 21' ist es möglich, die Winkellage beziehungsweise den Keilfehler zwischen dem Substrathalter und dem Erfassungsmittel an entsprechen vielen Stellen zu bestimmen, ohne das Erfassungsmittel in x-y-Richtung bewegen zu müssen. Da die Lage der jeweiligen erfassten Justierungsmarke 15, 15' zu den Justierungsmarken 15 des Justierungsmarkierungsfeldes bekannt ist, kann diese Positions- und Lageinformation zur Optimierung von Bewegungen oder zur Einstellung von Abständen, insbesondere Bondgaps verwendet werden. Vorzugsweise ist nicht nur die Lage der erfassten Justierungsmarke 15, 15' zu den Justierungsmarken 15, 15' der gleichen Ebene bekannt, sondern auch die Lage der jeweiligen Ebene der erfassten Justierungsmarke 15, 15' zu den anderen Ebenen des Justierungsmarkierungsfeldes.

Figur 3 zeigt einen Ausschnitt einer möglichen Ausführungsform eines Justierungsmarkierungsfeldes 14", wobei die einzelnen exemplarischen Justierungsmarken 15' mit maschinenlesbarem Code ergänzt sind. Dabei können die einzelnen Justierungsmarken 15 auf unterschiedlichen Ebenen (Stufen und/oder Schichten) angeordnet sein und eine Angabe, um welche Ebene es sich jeweils handelt, in dem Code enthalten sein. Weiterhin kann eine eindeutige Angabe der Position und Lage der jeweiligen Justierungsmarke 15' in dem Code enthalten sein.

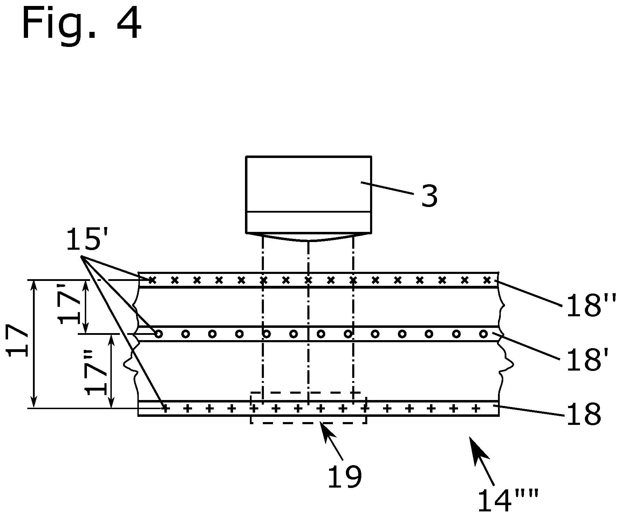

In Figur 4 ist eine Ausführungsform eines Justierungsmarkierungsfeldes 14ʺʺ in einer Schnittansicht dargestellt. Die Justierungsmarken 15' des Justierungsmarkierungsfeldes 14ʺʺ sind in drei unterschiedlichen Ebenen 18, 18', 18'' angeordnet und durch die Erfassungseinheit 3 erfassbar. Dabei kann die Erfassungseinheit 3 lediglich die Justierungsmarken 15' innerhalb des Fokusbereiches 19 erfassen. Denkbar ist auch, dass die Erfassungseinheit 3 elektromagnetische Strahlung unterschiedlicher Wellenlänge verwendet, um übereinander angeordnete Justiermarkierungen unterschiedlicher Ebenen zu erfassen. Das Justiermarkierungsfeld ist dann entsprechend für die unterschiedlichen Wellenlängen zumindest teilweise transparent.

Eine erste Ebene 18 weist dabei zu einer zweiten Ebene 18' einen bekannten Abstand 17" auf. Die zweite Ebene 18' weist zu einer dritten Ebene 18'' den ebenfalls bekannten Abstand 17' auf. Zudem ist der Abstand 17 zwischen der ersten Ebene 18 und der dritten Ebene 18'' bekannt. Der Abstand 17" und der Abstand 17' sind in der dargestellten Ausführungsform unterschiedlich groß, so dass bei der Verwendung des Justierungsmarkierungsfeldes 14ʺʺ zur Justierung eines Erfassungsmittels jeweils alle drei Abstände 17, 17' und 17" anfahrbar beziehungsweise einstellbar sind. Somit können die unterschiedlichen Abstände zwischen dem Erfassungsmittel 3 und einer Justierungsmarkierung erfasst werden. Gleichzeitig kann der bekannte Abstand zu einer anderen Ebene vorteilhaft angefahren werden.

Kombinationen der Abstände 17, 17', 17" können durch mehrfaches Bewegen des zu dem Justierungsmarkierungsfeld 14ʺʺ ortsfesten Substrathalters (9) auch angefahren werden, welche als Fokussierbewegung des Erfassungsmittels 3 durchführbar ist. Beispielsweise kann zunächst der fokussierte Abstand 17" eingestellt werden und im Anschluss der in derselben Richtung der Abstand 17' dazu angefahren werden. Auch kann zum Beispiel der Substrathalter um den doppelte Abstand 17" bewegt werden. Dazu wird in zwei Schritten ausgerichtet und die Erfassungseinheit entsprechend zwischen den Schritten eingestellt, da eine Fokusposition und damit der Fokusbereich 19 der Erfassungseinheit 3 angepasst wird.

In den Figuren 5a und 5b wird die Optik 3 in einer ersten Position 23 und in einer zweiten Position 24 (nach einer Justierung) dargestellt. Der Keilfehler (Winkel 22) zwischen der Optik 3 und dem Substrathalter, also der Winkelfehler zwischen einer optische Achse 25 der Optik 3 und der Substrathalteroberfläche 20 des Substrathalters 9, ist in der ersten Position 23 vorhanden und in der zweiten Position 24 ausgeglichen beziehungsweise nicht mehr vorhanden. Die Optik 3 kann somit vorteilhaft anhand von der Erfassung zweier Justiermarkierungen unterschiedlicher Ebenen 18, 18', 18" justiert werden.

### Bezugszeichenliste

- 1: Ausrichtungsanlage mit Vorrichtung zur Justierung eines Erfassungsmittels
- 2: optisches System
- 3: Erfassungsmittel, Erfassungseinheit, Optik
- 4: Positioniervorrichtung
- 5: zusätzliches Messsystem
- 6: Erfassungseinheit für Substrathalterrückseite, zusätzliches Erfassungsmittel
- 7: Positioniervorrichtung des zusätzlichen Messsystems
- 8: Gestell, Tisch
- 9: Substrathalter, erster (auszurichtender) Substrathalter
- 10: Bewegungseinrichtung des auszurichtenden Substrathalters
- 11: zweiter Substrathalter
- 12: Zweite Bewegungseinrichtung
- 13: Substratverformungsvorrichtung
- 14, 14', 14'', 14‴: Justierungsmarkierungsfeld, Ausrichtungsmarkierungsfeld
- 15, 15': Justierungsmarken, Justierungsmarkierungen, Referenzmarkierungen
- 16, 16': Schichten eines Justierungsmarkierungsfeldes
- 17, 17', 17": Abstand der übereinander angeordneten Justiermarken
- 18, 18', 18": Ebenen des Justierungsmarkierungsfeldes
- 19: Fokusbereich der Erfassungsmittel, Fokusbereich der Optik
- 20: Substrathalteroberfläche
- 21, 21': Erhöhungen, Pinne, Noppen
- 22: Winkel, Keilfehler
- 23: erste Position
- 24: zweite (justierte) Position
- 25: optische Achse

## Patentansprüche

1. Vorrichtung zur Justierung eines Erfassungsmittels (3, 6), zumindest aufweisend:
i) einen Substrathalter (9) zur Aufnahme eines Substrates,
ii) mindestens ein zu dem Substrathalter (9) ortsfest angeordnetes Justiermarkierungsfeld (14, 14', 14'', 14‴) mit Justiermarken (15, 15') und
iii) das Erfassungsmittel (3, 6) zur Erfassung der Justiermarken (15, 15'),
**dadurch gekennzeichnet, dass** das Erfassungsmittel (3, 6) anhand von übereinander angeordneten Justiermarken (15, 15') des Justiermarkierungsfeldes (14, 14', 14'', 14‴) relativ zu dem Substrathalter (9) justierbar ist, wobei der Substrathalter (9) auf einer Substrathalteroberfläche (20) regelmäßig angeordnete Erhöhungen (21, 21') zur Bereitstellung einer Substrataufnahmefläche aufweist und wobei mehrere jeweils Justiermarken (15, 15') aufweisende Justiermarkierungsfelder (14, 14', 14", 14‴) regelmäßig zueinander versetzt zwischen den Erhöhungen (21, 21') angeordnet sind.

2. Vorrichtung nach Anspruch 1, wobei die Justiermarken (15, 15') des Justiermarkierungsfeldes (14, 14', 14'', 14‴) in einer ersten Ebene (18, 18',18") und einer zweiten Ebene (18, 18',18") angeordnet sind, und wobei die erste Ebene (18, 18',18") und die zweiten Ebene (18, 18',18") parallel zueinander angeordnet sind, und wobei die erste Ebene (18, 18',18") und die zweite Ebene (18, 18',18") einen Abstand (17, 17', 17") zueinander aufweisen.

3. Vorrichtung nach wenigstens einem der vorhergehenden Ansprüche, wobei das Erfassungsmittel (3, 6) durch eine Relativbewegung zwischen dem Erfassungsmittel (3, 6) und dem Substrathalter (9) justierbar ist.

4. Vorrichtung nach wenigstens einem der vorhergehenden Ansprüche, wobei das Erfassungsmittel (3, 6) durch einen Fokuswechsel des Erfassungsmittels (3, 6) justierbar ist.

5. Vorrichtung nach wenigstens einem der vorhergehenden Ansprüche, wobei die Justiermarken (15, 15') der ersten Ebene (18, 18',18") und die Justiermarken (15, 15') der zweiten Ebene (18, 18',18") übereinander fluchtend angeordnet sind.

6. Vorrichtung nach wenigstens einem der vorhergehenden Ansprüche, wobei die Justiermarken (15, 15') der ersten Ebene (18, 18',18") und die Justiermarken (15, 15') der zweiten Ebene (18, 18',18") übereinander und regelmäßig versetzt zueinander angeordnet sind.

7. Vorrichtung nach wenigstens einem der vorhergehenden Ansprüche, wobei die Justiermarken (15, 15') der ersten Ebene (18, 18',18") und die Justiermarken (15, 15') der zweiten Ebene (18, 18',18") stufenartig versetzt zueinander auf unterschiedlichen Schichten (16, 16') angeordnet sind.

8. Vorrichtung nach wenigstens einem der vorhergehenden Ansprüche, wobei die Justiermarken (15, 15') jeweils zusätzlich einen individuellen und von dem Erfassungsmittel (3, 6) erfassbaren Informationsgehalt aufweisen.

9. Vorrichtung nach wenigstens einem der vorhergehenden Ansprüche, wobei das Erfassungsmittel (3, 6) ein optisches Erfassungsmittel, insbesondere eine Optik mit einer bestimmbaren optischen Zentralachse, ist.

10. Vorrichtung nach wenigstens einem der vorhergehenden Ansprüche, wobei eine der zwei Ebenen des mindestens einen Justiermarkierungsfeldes (14, 14', 14", 14‴) auf der Substrathalteroberfläche (20) liegt.

11. Vorrichtung nach wenigstens einem der vorhergehenden Ansprüche, wobei das mindestens eine Justiermarkierungsfeld (14, 14', 14", 14‴) in den Substrathalter (9) vollständig eingelassen ist und der zumindest teilweise unterhalb der Substrathalteroberfläche (20) angeordnet ist.

12. Vorrichtung nach wenigstens einem der vorhergehenden Ansprüche, wobei das Erfassungsmittel (3, 6) zum Auslesen von Ausrichtungsmarkierungen eines Substrates verwendbar ist.

13. Verfahren zur Justierung eines Erfassungsmittels mit zumindest den folgenden Schritten:
i) Bereitstellung eines Substrathalters (9) mit einem ortsfest zu dem Substrathalter (9) angeordneten Justiermarkierungsfeldes (14, 14', 14'', 14‴) mit Justiermarken (15, 15') und
i) Justierung des Erfassungsmittels (3, 6) relativ zu dem Substrathalter (9),
**dadurch gekennzeichnet, dass** das Erfassungsmittel (3, 6) anhand von übereinander angeordneten Justiermarken (15, 15') des Justiermarkierungsfeldes (14, 14', 14'', 14‴) justiert wird, wobei der Substrathalter (9) auf einer Substrathalteroberfläche (20) regelmäßig angeordnete Erhöhungen (21, 21') zur Bereitstellung einer Substrataufnahmefläche aufweist und wobei mehrere jeweils Justiermarken (15, 15') aufweisende Justiermarkierungsfelder (14, 14', 14'', 14‴) regelmäßig zueinander versetzt zwischen den Erhöhungen (21, 21') angeordnet sind.

14. Verfahren nach Anspruch 13, wobei das Justieren des Erfassungsmittels in Schritt ii) die folgenden Schritte mit dem folgenden Ablauf aufweist:
a) Erfassung einer ersten Justiermarke einer ersten Ebene (18, 18',18") des Justiermarkierungsfeldes (14, 14', 14'', 14‴),
b) Erfassung einer zweiten Justiermarke einer zweiten Ebene (18, 18',18") des Justiermarkierungsfeldes (14, 14', 14'', 14‴),
c) Ermittlung eines Keilfehlers zwischen dem Erfassungsmittel (3, 6) und dem Substrathalter (9),
d) Ausgleichung des in Schritt c) ermittelten Keilfehlers,
wobei die erste Ebene (18, 18',18") und die zweite Ebene (18, 18',18") zueinander parallel angeordnet sind, und wobei die erste Ebene (18, 18',18") und die zweite Ebene (18, 18',18") einen Abstand (17, 17', 17") zueinander aufweisen.

## Claims

1. A device for adjusting a detection means (3, 6), at least comprising
i) a substrate holder (9) for mounting a substrate,
ii) at least one adjustment marking field (14, 14', 14", 14‴) with adjustment marks (15, 15') arranged fixed with respect to the substrate holder (9) and
iii) the detection means (3, 6) for detecting the adjustment marks (15, 15'),
**characterised in that** the detection means (3, 6) is adjustable relative to the substrate holder (9) with the aid of adjustment marks (15, 15') of the adjustment marking field (14, 14', 14", 14"') arranged above one another, wherein the substrate holder (9) comprises elevations (21, 21') arranged regularly on a substrate holder surface (20) for providing a substrate mounting surface and wherein a plurality of adjustment marking fields (14, 14', 14", 14"') each comprising adjustment marks (15, 15') are arranged regularly offset from one another between the elevations (21, 21').

2. The device according to claim 1, wherein the adjustment marks (15, 15') of the adjustment marking field (14, 14', 14", 14‴) are arranged in a first plane (18, 18', 18") and a second plane (18, 18', 18"), and wherein the second first plane (18, 18', 18") and the second plane (18, 18', 18") are arranged parallel to one other, and wherein the first plane (18, 18', 18") and the second plane (18, 18', 18") have a distance (17, 17', 17") from each other.

3. The device according to at least one of the preceding claims, wherein the detection means (3, 6) can be adjusted by a relative movement between the detection means (3, 6) and the substrate holder (9).

4. The device according to at least one of the preceding claims, wherein the detection means (3, 6) can be adjusted by a change of focus of the detection means (3, 6).

5. The device according to at least one of the preceding claims, wherein the adjustment marks (15, 15') of the first plane (18, 18', 18") and the adjustment marks (15, 15') of the second plane (18, 18', 18") are arranged aligned one above the other.

6. The device according to at least one of the preceding claims, wherein the adjustment marks (15, 15') of the first plane (18, 18', 18") and the adjustment marks (15, 15') of the second plane (18, 18', 18") are arranged above one another and regularly offset with respect to one another.

7. The device according to at least one of the preceding claims, wherein the adjustment marks (15, 15') of the first plane (18, 18', 18") and
the adjustment marks (15, 15') of the second plane (18, 18', 18") are arranged offset step-like with respect to one another on different layers (16, 16').

8. The device according to at least one of the preceding claims, wherein the adjustment marks (15, 15') each also contain individual information content which is detectable by the detection means (3, 6).

9. The device according to at least one of the preceding claims, wherein the detection means (3, 6) is an optical detection means, in particular a lens with a determinable optical central axis.

10. A device according to at least one of the preceding claims, wherein one of the two planes of the at least one adjustment marking field (14, 14', 14", 14‴) lies on the substrate holder surface (20).

11. The device according to at least one of the preceding claims, wherein the at least one adjustment marking field (14, 14', 14", 14"') is completely embedded in the substrate holder (9) and which is at least partially arranged below the substrate holder surface (20).

12. The device according to at least one of the preceding claims, wherein the detection means (3, 6) can the used for reading out alignment markings of a substrate.

13. A method for adjusting a detection means with at least the following steps:
i) provision of a substrate holder (9) with an adjustment marking field (14, 14', 14", 14‴) with adjustment marks (15, 15') arranged fixed with respect to the substrate holder (9) ' and
i) adjustment of the detection means (3, 6) relative to the substrate holder (9),
**characterised in that** the detection means (3, 6) is adjusted with the aid of adjustment marks (15, 15') of the adjustment marking field (14, 14', 14" 14‴) arranged above one another, wherein the substrate holder (9) comprises elevations (21, 21') arranged regularly on a substrate holder surface (20) for the provision of a substrate mounting surface and wherein a plurality of adjustment marking fields (14, 14', 14", 14"') each comprising adjustment marks (15, 15') are arranged regularly offset from one another between the elevations (21, 21').

14. The method according to claim 13, wherein the adjustment of the detection means in step ii) involves the following steps with the following sequence:
a) detection of a first adjustment mark of a first plane (18, 18', 18") of the adjustment marking field (14, 14', 14", 14‴),
b) detection of a second adjustment mark of a second plane (18, 18', 18") of the adjustment marking field (14, 14', 14", 14"'),
c) determination of a wedge error between the detection means (3, 6) and the substrate holder (9),
d) compensation for the wedge error determined in step c),
wherein the first plane (18, 18', 18") and the second plane (18, 18', 18") are arranged parallel to one another, and the first plane (18, 18', 18") and the second plane (18, 18', 18") have a distance (17, 17', 17") from one another.

## Revendications

1. Dispositif de calibrage d'un moyen de détection (3, 6), présentant au moins :
i) un support de substrat (9) destiné à accueillir un substrat ;
ii) au moins un champ de marquage de calibrage disposé à emplacement fixe (14, 14', 14", 14"') par rapport au support de substrat (9), avec des marques de calibrage (15, 15') et
iii) le moyen de détection (3, 6) pour enregistrer les marques de calibrage (15, 15') ;
**caractérisé en ce que** le dispositif de détection (3, 6) peut être ajusté par rapport au support de substrat (9) à partir de marques de calibrage superposées les unes aux autres (15, 15') du champ de marquage de calibrage (14, 14', 14", 14‴), le support de substrat (9) présentant des protubérances (21, 21') disposées régulièrement sur une surface de support de substrat (20) pour créer une surface de réception de substrat et plusieurs champs de marquage de réglage (14, 14', 14", 14‴), présentant respectivement des marques de calibrage (15, 15'), étant disposés régulièrement décalés entre les protubérances (21, 21').

2. Dispositif selon la revendication 1, dans lequel les marques de calibrage (15, 15') du champ de marquage de calibrage (14, 14', 14", 14"') sont disposés dans un premier plan (18, 18', 18") et un second plan (18, 18', 18''), le premier plan (18, 18', 18") et le second plan (18, 18', 18") sont disposés parallèlement l'un à l'autre ; et le premier plan (18, 18',18") et le second plan (18, 18',18") présentant une distance (17, 17', 17'') l'un par rapport à l'autre.

3. Dispositif selon au moins une des revendications précédentes, dans lequel le moyen de détection (3, 6) peut être ajusté par un mouvement relatif entre le moyen de détection (3, 6) et le support de substrat (9).

4. Dispositif selon au moins une des revendications précédentes, dans lequel le moyen de détection (3, 6) peut être ajusté par un changement de focus du moyen de détection (3, 6).

5. Dispositif selon au moins une des revendications précédentes, dans lequel les marques de calibrage (15, 15') du premier plan (18, 18', 18") et les marques de calibrage (15, 15') du second plan (18, 18', 18") sont disposées alignées les unes sur les autres.

6. Dispositif selon au moins une des revendications précédentes, dans lequel les marques de calibrage (15, 15') du premier plan (18, 18', 18") et les marques de calibrage (15, 15') du second plan (18, 18', 18") sont superposées et régulièrement décalées les unes par rapport aux autres.

7. Dispositif selon au moins une des revendications précédentes, dans lequel les marques de calibrage (15, 15') du premier plan (18, 18', 18") et
les marques de calibrage (15, 15') du second plan (18, 18', 18") sont disposées graduellement décalées les unes par rapport aux autres sur différentes couches (16, 16').

8. Dispositif selon au moins une des revendications précédentes, dans lequel les marques de calibrage (15, 15') présentent en outre respectivement une teneur informative individuelle et détectable par le moyen de détection (3, 6).

9. Dispositif selon au moins une des revendications précédentes, dans lequel le moyen de détection (3, 6) est un moyen de détection optique, en particulier une optique avec un axe optique central définissable.

10. Dispositif selon au moins une des revendications précédentes, dans lequel l'un des deux plans d'au moins un champ de marquage de calibrage (14, 14', 14", 14"') est situé sur la surface du support de substrat (20).

11. Dispositif selon au moins une des revendications précédentes, avec au moins un champ de marquage de réglage (14, 14', 14", 14"') entièrement intégré dans le support de substrat (9) et disposé au moins partiellement en dessous de la surface du support de substrat (20).

12. Dispositif selon au moins une des revendications précédentes, dans lequel le moyen de détection (3, 6) peut être utilisé pour la lecture des marquages d'orientation d'un substrat.

13. Procédé de calibrage d'un moyen de détection comprenant au moins les étapes suivantes :
i) prévision d'un support de substrat (9) avec un champ de marquage de calibrage (14, 14', 14'', 14"') disposé fixement par rapport au support de substrat (9), avec des marques de calibrage (15, 15'), et
i) calibrage du moyen de détection (3, 6) par rapport au support de substrat (9),
**caractérisé en ce que** le moyen de détection (3, 6) est calibré à l'aide de marques de calibrage superposés (15, 15') du champ de marquage de calibrage (14, 14', 14", 14‴), le support de substrat (9) présentant des protubérances (21, 21') disposées régulièrement sur une surface de support de substrat (20) pour créer une surface de réception de substrat et plusieurs champs de marquage de calibrage (14, 14', 14'', 14‴) présentant respectivement des marques de calibrage (15, 15') étant disposés régulièrement décalés entre les protubérances (21, 21').

14. Procédé selon la revendication 13, dans lequel le calibrage du moyen de détection à l'étape ii) comporte les étapes suivantes, avec le déroulement suivant :
a) la détection d'une première marque de calibrage d'un premier plan (18, 18', 18'') du champ de marquage de calibrage (14, 14', 14'', 14"') ;
b) la détection d'une seconde marque de calibrage d'un second plan (18, 18', 18'') du champ de marquage de calibrage (14, 14', 14", 14"') ;
c) l'identification d'une erreur d'angle entre le dispositif de détection (3, 6) et le support de substrat (9) ;
d) la correction de l'erreur d'angle constatée à l'étape c) ;
le premier plan (18, 18', 18") et le second plan (18, 18', 18'') étant disposés parallèlement l'un à l'autre, le premier plan (18, 18', 18") et le second plan (18, 18', 18") présentant une distance (17, 17', 17") l'un par rapport à l'autre.
